# EUROPEAN PATENT APPLICATION

(11) **EP 4 836 599 A1**
(43) Date of publication of application: **04.11.2026**
(21) Application number: 24912367.0
(22) Date of filing: 11.12.2024
(51) Int. Cl.: H05K 3/00, H05K 1/02, H05K 3/46

(54) **MULTILAYER WIRING BOARD, METHOD FOR MANUFACTURING MULTILAYER WIRING BOARD, AND MULTILAYER WIRING BASE BOARD**

(30) Priority: 28.12.2023 JP 2023222763
(71) Applicant: Toppan Holdings Inc., Tokyo 110-0016 (JP)
(72) Inventor: ISHII, Tomoyuki, Tokyo 110-0016 (JP)
(74) Representative: Plasseraud IP
(86) International application number: PCT/JP2024/043750
(87) International publication number: WO 2025/142478

(57) **Abstract**

An object of the present invention is to provide a technique that enables preventing the core substrate from being damaged even when the core substrate is thick, thereby ensuring the reliability of the multilayer wiring board, and a technique that can reduce the manufacturing steps and manufacturing cost of the multilayer wiring board. A multilayer wiring board (1) according to the present invention includes: a core substrate (10) having a first surface (10a), a second surface (10b) opposing the first surface (10a), and a side surface (10c) connecting peripheral portions of the first surface (10a) and the second surface (10b); a first wiring layer (21) that is a wiring layer formed on the first surface (10a); and a second wiring layer (22) that is a wiring layer formed on the second surface (10b), wherein, in a cross-sectional view along a direction perpendicular to the first surface (10a) and the second surface (10b), the side surface (10c) has a shape that protrudes outward from the core substrate (10) beyond a straight line connecting an intersection point of the first surface (10a) and the side surface (10c) with an intersection point of the second surface (10b) and the side surface (10c), and the side surface (10c) is covered by an insulating resin portion (24).

## Description

### [Technical Field]

The present invention relates to a multilayer wiring board, a method for manufacturing a multilayer wiring board, and a multilayer wiring base substrate.

### [Background Art]

The need for higher-density multilayer wiring boards for semiconductor devices is growing as electronic devices become more functional and smaller. Conventionally, organic materials, typically glass epoxy resin, have generally been used as the material for multilayer wiring boards. In recent years, advances in hole-forming technology for glass materials have made it possible to, for example, form small-diameter through-holes of 100 µm or less at a pitch of 150 µm or less in a 300 µm thick glass substrate. As a result, glass has gained significant attention as a material for electronic circuit boards.

In the manufacturing process of multilayer wiring boards using a glass material as the core substrate, grinding is performed for singulation. Very fine cracks are formed at the edge faces of the singulated glass substrates by the grinding process. These cracks propagate due to stress caused by the difference in linear expansion coefficients between the glass substrate and the wiring layers, resulting in microcracks that grow into the interior of the glass substrate. Since microcracks affect the reliability of multilayer wiring boards, measures to address them are being studied.

For example, PTL 1 addresses the challenge of providing a glass core device, at low cost, having reliability and sufficient mechanical strength by flattening and protecting the surfaces of a glass core in which TGVs are formed, and a method of producing the glass core device. It discloses the following as the glass core device and its production method.

"In a glass core device, a wiring pattern on a first surface 10a of a glass core 10 and a wiring pattern on a second surface 10b thereof are electrically connected via a wiring pattern embedded in TGVs 11 formed in the glass core 10. In a singulated state after dicing, the glass core device has an outer protective layer 62 that continuously covers the side surfaces and second surface 10b of the glass core 10."

### [Citation List]

### [Patent Literature]

PTL 1: JP 7106875 B

### [Summary of the Invention]

### [Problem to be Solved by the Invention]

In PTL 1, a glass core device with a peripheral protective layer is manufactured by coating grooves formed in the glass core with a protective resin that forms the outer protective layer, followed by dicing. This singulates the glass core with the insulating resin adhered to its periphery, thereby forming a glass core device with a peripheral protective layer. However, if the thickness of the glass core increases, it becomes difficult to coat the grooves in the glass core with the insulating resin, making it difficult to sufficiently provide the insulating resin over the entire sidewall of the glass core device. PTL 1 does not sufficiently consider this point.

Therefore, an object of the present invention is to provide a technique that enables preventing the core substrate from being damaged even when the core substrate is thick, thereby ensuring the reliability of the multilayer wiring board.

### [Solution to Problem]

To solve the above problem, a representative multilayer wiring board of the present invention includes: a core substrate having a first surface, a second surface opposing the first surface, and a side surface connecting peripheral portions of the first surface and the second surface; a first wiring layer that is a wiring layer formed on the first surface; and a second wiring layer that is a wiring layer formed on the second surface, wherein, in a cross-sectional view along a direction perpendicular to the first surface and the second surface, the side surface has a shape that protrudes outward from the core substrate beyond a straight line connecting an intersection point of the first surface and the side surface with an intersection point of the second surface and the side surface, and the side surface is covered by an insulating resin portion.

### [Advantageous Effects of the Invention]

According to the present invention, it is possible to prevent the core substrate from being damaged even when the core substrate is thick, thereby ensuring the reliability of the multilayer wiring board. Problems, configurations, and effects other than those described above will become clear from the following description of embodiments.

### [Brief Description of the Drawings]

FIG. 1 is a cross-sectional view illustrating a multilayer wiring board according to a first embodiment.
FIG. 2 is a cross-sectional view illustrating an enlarged view of the structure of a through-electrode in the multilayer wiring board according to the first embodiment.
FIG. 3 is a cross-sectional view illustrating the step of preparing the glass substrate in the manufacturing method according to the first embodiment.
FIG. 4 is a cross-sectional view illustrating the step of forming laser-modified portions in the manufacturing method according to the first embodiment.
FIG. 5 is a diagram illustrating the locations where the laser-modified portions are formed in the manufacturing method according to the first embodiment.
FIG. 6 is a cross-sectional view illustrating the step of forming the first through-hole portions by etching in the manufacturing method according to the first embodiment.
FIG. 7 is a cross-sectional view illustrating the step of forming the first wiring layer in the manufacturing method according to the first embodiment.
FIG. 8 is a cross-sectional view illustrating the step of forming laser-modified portions in the manufacturing method according to the first embodiment.
FIG. 9 is a cross-sectional view illustrating the bonding step of the first support in the manufacturing method according to the first embodiment.
FIG. 10 is a cross-sectional view illustrating the step of forming the second through-hole portions by etching in the manufacturing method according to the first embodiment.
FIG. 11 is a bottom view of the glass substrate after the second separation-groove portions are formed.
FIG. 12 is a schematic enlarged view of a portion of the second separation-groove portion.
FIG. 13 is a schematic diagram illustrating side surfaces of the first and second separation-groove portions.
FIG. 14 is a schematic enlarged view of the separation-groove portion.
FIG. 15 is a schematic enlarged view of a portion of a bottom view of the separation grooves.
FIG. 16 is a cross-sectional view illustrating the step of forming the second wiring layer in the manufacturing method according to the first embodiment.
FIG. 17 is a cross-sectional view illustrating the removal step of the first support in the manufacturing method according to the first embodiment.
FIG. 18 is a cross-sectional view illustrating the step of forming the build-up layer in the manufacturing method according to the first embodiment.
FIG. 19 is a cross-sectional view illustrating the step of forming the connection pads in the manufacturing method according to the first embodiment.
FIG. 20 is a cross-sectional view illustrating the singulation step in the manufacturing method according to the first embodiment.
FIG. 21 illustrates a flowchart of the manufacturing method according to the first embodiment.
FIG. 22 is a cross-sectional view illustrating the step of forming laser-modified portions in the manufacturing method according to the first modification.
FIG. 23 is a cross-sectional view illustrating the step of forming through-holes by etching in the manufacturing method according to the first modification.
FIG. 24 illustrates a flowchart of a manufacturing method according to the first modification.
FIG. 25 is a diagram explaining the overlap ratio of the laser-modified portions and the through-holes.
FIG. 26 is a cross-sectional view illustrating a multilayer wiring board according to a second embodiment.
FIG. 27 is a cross-sectional view illustrating an enlarged view of the structure of a through-electrode in the multilayer wiring board according to a third embodiment.
FIG. 28 is a cross-sectional view illustrating a multilayer wiring board according to a fourth embodiment.
FIG. 29 is a schematic perspective view of a multilayer wiring board.
FIG. 30 is a schematic diagram illustrating the multilayer wiring base substrate.

### [Description of the Embodiments]

Embodiments of the present invention will be described below with reference to the drawings.

It should be noted that the description below relates to examples of the present invention, and the invention is not limited by these examples. In the following description of the drawings, components identical with each other are given the same reference signs.

The position, size, shape, extent, and the like of each component shown in the drawings may not represent their actual position, size, shape, extent, and the like to facilitate understanding of the invention. Therefore, the present invention is not necessarily limited to the positions, sizes, shapes, extent, and the like shown in the drawings.

In the present disclosure, "surface" may refer not only to a surface of a plate-like member but also to the interface of a layer included in the plate-like member that is substantially parallel to a surface of the plate-like member. Furthermore, when a plate-like member or a layer included in the plate-like member is illustrated, "upper surface" and "lower surface" refer to surfaces illustrated on the upper and lower sides, respectively, in the drawing. The "upper surface" and "lower surface" may also be referred to as "first surface" and "second surface."

Furthermore, "side surface" refers to the surface or layer thickness portion of a plate-like member or a layer in the plate-like member. A portion of a surface and a side surface together may be referred to as an "edge portion."

The term "upper side" refers to a vertically upward direction when a plate-like member or a layer is placed horizontally. Additionally, "upper side" and the opposite direction, "lower side," may be referred to as the "positive z-axis direction" and the "negative z-axis direction," respectively. For horizontal directions, they may be referred to as an "x-axis direction" or a "y-axis direction."

### <First Embodiment>

### (Structure of Multilayer Wiring Board)

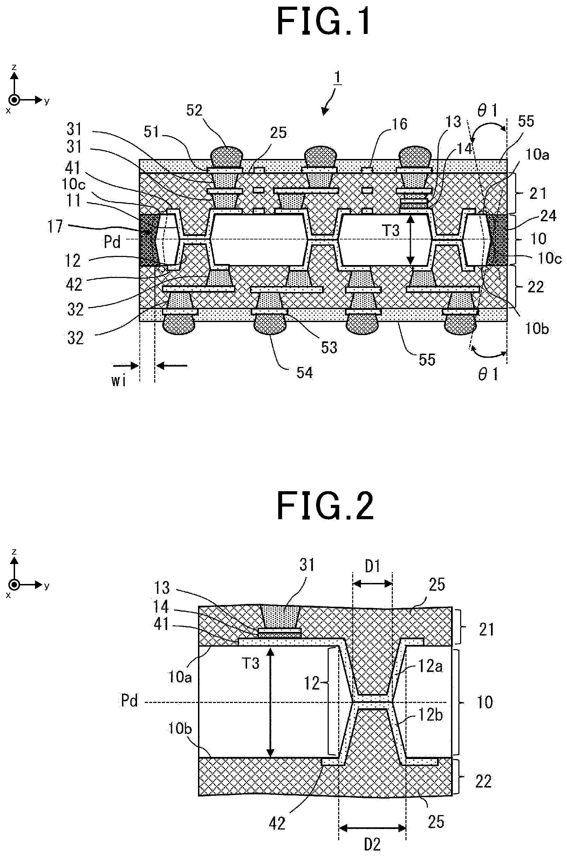

Referring to Figs. 1 and 2, a multilayer wiring board according to the first embodiment will be described. FIG. 1 is a cross-sectional view illustrating the multilayer wiring board according to the first embodiment. FIG. 2 is a cross-sectional view illustrating an enlarged view of the structure of a through-electrode in the multilayer wiring board according to the first embodiment. As illustrated in Figs. 1 and 2, a multilayer wiring board 1 includes a core substrate 10 made of glass material. The core substrate 10 has a first wiring layer 21 formed on its upper surface in the positive z-axis direction (hereinafter also referred to as "first surface 10a") and a second wiring layer 22 formed on its lower surface in the negative z-axis direction (hereinafter also referred to as "second surface 10b").

The core substrate 10 has the first surface 10a, the second surface 10b opposing the first surface 10a, and a side surface 10c connecting the peripheral edge of the first surface 10a and the peripheral edge of the second surface 10b. Figs. 1 and 2 show cross-sectional views along a direction perpendicular to the first and second surfaces 10a and 10b. The side surface 10c has a shape that protrudes outward from the core substrate (in the positive or negative y-axis direction), relative to a straight line connecting the intersection point between the first surface 10a and the side surface 10c and the intersection point between the second surface 10b and the side surface 10c. The side surface 10c is covered by an insulating resin portion 24. In FIG. 1, the side surface 10c is located at the edge portions of the core substrate 10 in the y-axis direction, as enclosed by a dotted line. When the position where the side surface 10c protrudes the most between the first and second surfaces 10a and 10b is defined as an intermediate portion Pd, the side surface 10c of the core substrate 10 exhibits a shape protruding from the core substrate 10 toward the insulating resin portion 24 at the intermediate portion Pd (in other words, it exhibits a boundary line convex toward the positive y-axis direction and a cross-section convex toward the negative y-axis direction). In the present disclosure, the intermediate portion Pd is described as being located at a position corresponding to half the thickness T3 of the core substrate 10, but the present disclosure is not limited thereto. The intermediate portion Pd may be located anywhere between the first and second surfaces 10a and 10b of the core substrate 10.

The core substrate 10 is formed with through-holes 11 extending from the first surface 10a to the second surface 10b, in other words, extending between the front and back surfaces. Each through-hole 11 is configured such that the opening width of the opening in the first surface 10a decreases as it approaches the intermediate portion Pd, and the opening width of the opening in the second surface 10b also decreases as it approaches the intermediate portion Pd. Specifically, FIG. 1 shows a case where there are three through-holes 11. Furthermore, as illustrated in FIG. 2, the through-holes 11 have a shape symmetrical with respect to the intermediate portion Pd, resembling two conical frustums combined. When the opening width of each through-hole 11 in the first surface 10a and the opening width of the through-hole 11 in the second surface 10b are both D2, the opening width decreases as it approaches the intermediate portion Pd, becoming D1 near the intermediate portion Pd. A through-electrode 12 is disposed on each through-hole 11. The through-electrode 12 includes a seed metal layer (hereinafter also referred to simply as a "seed layer") formed on the inner wall surface of the through-hole 11 and provides conduction between the first surface 10a side and the second surface 10b side of the core substrate 10 through the through-hole 11. Furthermore, as illustrated in FIG. 2, a capacitor electrode 13 is disposed on the upper side of the through-electrode 12 in the first wiring layer 21. It is also possible to embed circuit elements other than capacitors, such as inductors, within the first wiring layer 21. In practice, the through-hole 11 may have a shape resembling a combination of quadratic curves rather than conical frustums. In the drawings, an ideal shape is illustrated for ease of understanding. The same applies to the aforementioned side surface 10c (separation groove 17).

Next, the configuration of the first wiring layer 21, which is a wiring layer formed on the first surface 10a of the core substrate 10, will be described. A through-electrode connection portion 41 (hereinafter also referred to as a "first conductive portion") is an electrode disposed in the first wiring layer 21 and connected to the through-electrode 12. Note that the through-electrode connection portion 41 and the through-electrode 12 share a common configuration, and the portion disposed on the first surface 10a is referred to as the through-electrode connection portion 41, while the portion disposed in the through-hole 11 is referred to as the through-electrode 12. A conductive electrode 31 is provided on the through-electrode connection portion 41. The capacitor electrode 13, a dielectric layer 14, and the through-electrode connection portion 41 form a metal-insulator-metal (MIM) structure. Furthermore, wiring 16 is wiring disposed within the first wiring layer 21 and is connected to the through-electrode 12, the conductive electrode 31, and the like. The through-electrode connection portion 41, the conductive electrode 31, the capacitor electrode 13, the dielectric layer 14, and the wiring 16 are all protected by an insulating resin layer 25. Furthermore, when the multilayer wiring board 1 is used as a relay board for connecting multiple semiconductor devices, that is, as an interposer substrate, the semiconductor-device bonding solder 52 provides a bump used when mounting another semiconductor device or connecting to another semiconductor device. A solder resist 55 is a film made of an insulating member for protecting the multilayer wiring board 1. Here, two conductive electrodes 31 are stacked within the first wiring layer 21. This indicates that the first wiring layer 21 is formed by stacking two wiring layers.

The configuration of the second wiring layer 22, which is a wiring layer formed on the second surface 10b of the core substrate 10, will be described. A through-electrode connection portion 42 (hereinafter also referred to as a "second conductive portion") is an electrode disposed within the second wiring layer 22 and connected to the through-electrode 12, and is formed to match the shape of the open end of the through-electrode 12. Note that the through-electrode connection portion 42 and the through-electrode 12 also share a common configuration, and the portion formed on the second surface 10b is referred to as the through-electrode connection portion 42, while the portion disposed in the through-hole 11 is referred to as the through-electrode 12. A conductive electrode 32 is connected to the through-electrode connection portion 42. Predetermined pairs of the through-electrode connection portions 42 disposed in the second wiring layer 22 and the through-electrode connection portions 41 disposed in the first wiring layer 21 are electrically connected to each other through respective through-electrodes 12. The board bonding solder 54 is a bump used for connection to a printed wiring board. A solder resist 55 is a film made of an insulating member for protecting the multilayer wiring board 1. Here, the conductive electrode 32 forms a conductive path within the second wiring layer 22 by being stacked or through another wiring layer. This indicates that the second wiring layer 22 is formed by stacking two wiring layers.

The first and second wiring layers 21 and 22 include the insulating resin layer 25, and the insulating resin portion 24 covering the side surface 10c of the core substrate 10 is made of the same type of insulating resin material as that forming the insulating resin layers 25. The side surface 10c of the core substrate 10 corresponds to the separation groove 17 and is a location at which the multilayer wiring board is separated from the glass substrate 60, as described later. The insulating resin portion 24 may be an insulating resin material disposed in the separation groove 17, or may be part of the insulating resin layer 25 disposed in the separation groove 17.

Furthermore, as illustrated in FIG. 2, the through-electrode 12 includes a first through-electrode 12a and a second through-electrode 12b. At a central portion of the through-hole 11, the seed layer of the first through-electrode 12a and the seed layer of the second through-electrode 12b are in contact with each other to form a layered structure.

### (Dimensions and Composition of Multilayer Wiring Board)

The ratio of the opening width D1 at the intermediate portion Pd of the through-electrode 12 to an opening width D2 on the first surface 10a side or the second surface 10b side (i.e., the opening width D1 at the intermediate portion/the opening width D2 on the first or second surface side) is within the range of 0.35 or more and 0.65 or less. The ratio of the opening width D1 at the intermediate portion to the opening width D2 on the first surface 10a side or the second surface 10b side can be set as appropriate as long as the ratio is within the above range.

The thickness T3 of the core substrate 10 is within the range of 150 µm or more and 2000 µm or less, and can be set in accordance with the characteristic value of the capacitor electrode 13, an inductor, a resistor, or the like formed in the first wiring layer 21. More preferably, the thickness T3 of the core substrate 10 is within the range of 300 µm or more and 1000 µm or less.

The insulating resin layer 25 has a relative permittivity of 3.1 or more and 3.5 or less and a dielectric loss tangent of 0.002 or more and 0.012 or less. The insulating resin layer 25 is formed of a thermosetting resin. An insulating resin material having such a relative permittivity and dielectric loss tangent is used for the insulating resin layer 25.

Examples of the thermosetting resin include an epoxy resin, a polyimide resin, a polyamide resin, and composite materials thereof, in which a filler material containing at least SiO₂ as a component is included in the range of 65% or more and 80% or less. If the filler content of the SiO₂ filler material is 65% or less, the relative permittivity and the dielectric loss tangent are outside the above ranges, which may deteriorate transmission characteristics. More preferably, the filler content of the SiO₂ filler material is 72% or more.

Among the above composite materials, a material highly loaded with the SiO₂ filler material results in an insulating resin with a low linear expansion coefficient that is close to that of a glass material. Accordingly, by using such a material, it is possible to reduce the stress that may occur when a wiring layer is formed on the core substrate 10. This allows the relative permittivity and dielectric loss tangent to be within the above ranges, thereby avoiding adverse effects on transmission characteristics.

On the side surface of the multilayer wiring board 1, the insulating resin layer 25 included in the first and second wiring layers 21 and 22, as well as the insulating resin portion 24 formed on the side surface of the core substrate 10, are exposed. A thickness wi of the insulating resin on the side portion of the multilayer wiring board 1 (in other words, the thickness of the insulating resin portion 24 on the side surface 10c of the core substrate 10) is at least 50 µm when measured in the xy-plane direction (the direction in which the multilayer wiring board 1 extends). Assuming that the angle between a vertical straight line extending from the first surface 10a toward the second surface 10b and a line parallel to the side surface 10c of the core substrate 10 is θ1, the angle θ1 is within the range of 21° or more and 35° or less. The side surface 10c has a substantially line-symmetric shape with respect to a line indicating the intermediate portion Pd, with inclined surfaces extending at an angle of θ1 in both the positive and negative z-axis directions from the intermediate portion Pd. In other words, the side surface 10c of the core substrate 10 may be described as having a so-called X-shape.

The side surface of the multilayer wiring board 1 is provided with the insulating resin layers 25 and the insulating resin portion 24, and thus the side surface of the multilayer wiring board 1 is protected by an insulating resin material. This makes it possible to distribute stress generated in the first wiring layer 21 or the second wiring layer 22 formed on the upper and lower surfaces of the core substrate 10, respectively, to the other wiring layer through the insulating resin portion 24 at the side surface 10c of the core substrate 10. Furthermore, it is possible to suppress the occurrence of microcracks at the edge portions of the core substrate 10 and chipping of the insulating resin material, thereby improving the reliability of the multilayer wiring board 1.

The capacitors formed in the first wiring layer 21 of the multilayer wiring board 1 have a MIM structure. From the perspectives of insulation properties and relative permittivity, at least one from alumina, silica, silicon nitride, tantalum oxide, titanium oxide, calcium titanate, barium titanate, and strontium titanate may be selected for the dielectric layer 14 forming a capacitor. Materials used for the upper and lower electrodes of the MIM structure may include, for example, at least one of Cu, Ni, Al, Ti, Cr, Mo, W, Ta, Au, Ir, Ru, Pd, Pt, AlSi, AlSiCu, AlCu, and NiFe. For example, Cu is a preferred material.

The core substrate 10 used in the multilayer wiring board 1 is made of a transparent glass material that transmits light. The glass may have any components or any mixing ratio of the contained components, and may also be produced by any method. For example, the glass may be non-alkali glass, alkali glass, borosilicate glass, quartz glass, sapphire glass, photosensitive glass, or the like. Any of these glass materials containing silicate as a main component may be used. Other glass materials may also be used. However, in the multilayer wiring board according to the present embodiment, non-alkali glass is preferably used.

The core substrate 10 employs glass produced by, for example, a float process, a down-draw process, a fusion process, an up-draw process, or a roll-out process. However, a glass material produced by any method may be used. The glass desirably has a linear expansion coefficient within the range of -1 ppm/K or more and 15.0 ppm/K or less. The reason is that if the coefficient is less than -1 ppm/K, it is difficult to select an appropriate glass material. On the other hand, if the coefficient exceeds 15.0 ppm/K, the difference in thermal expansion coefficient relative to the other layers becomes large, which reduces reliability when the glass is used in a multilayer wiring board. Moreover, when a silicon chip is mounted on the multilayer wiring board 1 of the present embodiment, the connection reliability with the silicon chip is reduced. The linear expansion coefficient of the glass is more preferably within the range of 0.5 ppm/K or more and 8.0 ppm/K or less, and even more preferably within the range of 1.0 ppm/K or more and 4.0 ppm/K or less.

### <First Manufacturing Method According to Embodiment of the Present Invention>

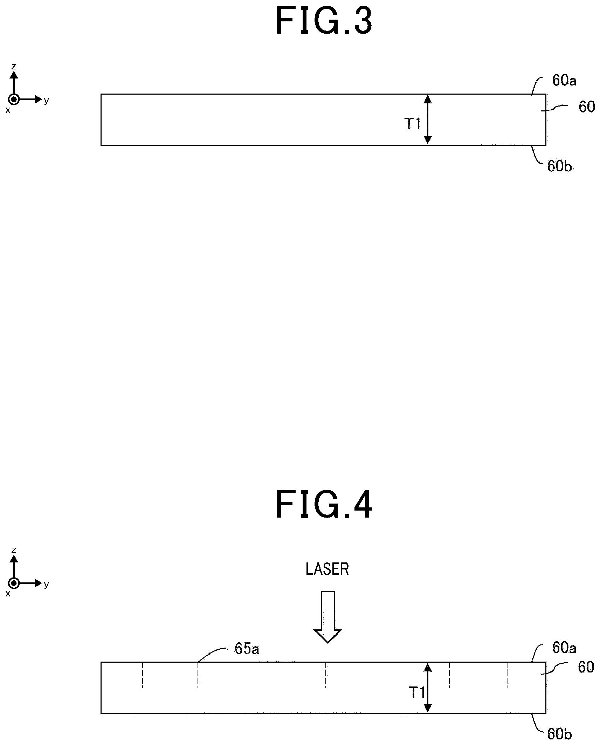

A method for manufacturing the multilayer wiring board 1 in the first embodiment will be described below with reference to Figs. 3 to 15. In the drawings described below, for ease of understanding, a portion of a glass substrate described later that includes one multilayer wiring board 1 is extracted and illustrated. A plurality of similar portions are arranged in the xy-plane of the glass substrate.

### (Preparation of Glass Substrate)

First, a step of preparing the glass substrate will be described with reference to FIG. 3. FIG. 3 is a cross-sectional view illustrating the step of preparing the glass substrate in the manufacturing method according to the first embodiment. As illustrated in FIG. 3, a base substrate (hereinafter also referred to as a "glass substrate") 60 having a first surface 60a and a second surface 60b opposite the first surface 60a is prepared. The glass substrate 60 has a thickness of T1. Although the present disclosure is described using the glass substrate 60, the present disclosure is not limited to a glass substrate. The present disclosure is also applicable to cases where materials other than glass are used.

### (Formation of Laser-Modified Portions on First Surface)

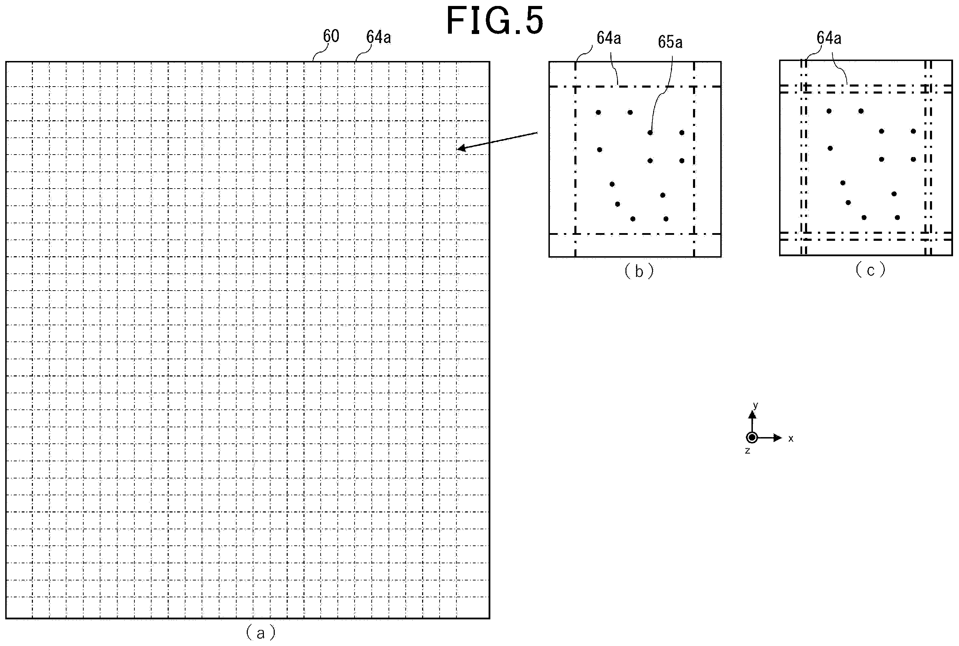

Next, a step of forming a laser-modified portion on the first surface 60a (a first step) will be described with reference to Figs. 4 and 5. The first step is a step of forming a first modified portion by laser irradiation from the first surface 60a side of the glass substrate 60 at a first through-hole position, which is a position where a first through-hole portion is to be formed, the first through-hole portion extending from the first surface 60a to an intermediate portion Pd of the glass substrate 60 and constituting part of a through-hole penetrating the glass substrate 60 from the first surface 60a toward the second surface 60b, and at a first singulation-line position indicating a position where a first separation-groove portion is to be formed, the first separation-groove portion extending from the first surface 60a to the intermediate portion Pd of the glass substrate 60 and constituting part of a separation groove for separating the multilayer wiring board 1 from the glass substrate 60.

FIG. 4 is a cross-sectional view illustrating the step of forming the laser-modified portion in the manufacturing method according to the first embodiment. In FIG. 4, the broken lines indicate laser-modified portions (first modified portions) 65a. As illustrated in FIG. 4, the glass substrate 60 is irradiated with laser light from the first surface 60a side to form the laser-modified portions 65a. The laser-modified portions 65a are formed at positions (first through-hole positions) corresponding to the through-holes 11 of the core substrate 10. Each laser-modified portion 65a extends, for example, in a vertical direction (z-axis direction) relative to the glass substrate 60, and reaches the vicinity of the intermediate portion Pd of the glass substrate 60. The intermediate portion Pd indicates the same position as the intermediate portion of the core substrate 10. Since the laser-modified portions 65a are used to form through-holes reaching the intermediate portion Pd, the depth to which they extend into the glass substrate 60 is adjusted in accordance with the through-hole formation step.

FIG. 5 is a diagram illustrating the locations where the laser-modified portions 65a are formed in the manufacturing method according to the first embodiment. FIG. 5(a) is a plan view of the glass substrate 60 as seen from the positive z-axis direction, that is, from the first surface 60a side, and FIG. 5(b) is an exemplary enlarged view of a portion of the glass substrate 60. Here, the dot-dashed lines indicate singulation lines 64a. Each singulation line 64a indicates a position (first singulation-line position) where the first separation-groove portion is to be formed, which extends from the first surface 60a to the vicinity of the intermediate portion Pd of the glass substrate 60 and constitutes part of the separation groove 17 for separating the multilayer wiring board 1 from the glass substrate 60. In addition to being formed at the first through-hole positions, laser-modified portions 65a are also formed along the singulation lines 64a. The laser-modified portions 65a formed at the first through-hole positions are indicated by black circles. By separating the glass substrate 60 along the singulation lines 64a, a plurality of multilayer wiring boards 1 are obtained.

FIG. 5(c) shows another example and is an enlarged view of a portion of the glass substrate 60. As illustrated in this diagram, in a case where the laser-modified portions 65a are formed, a plurality of laser-modified portions may be formed by shifting the laser irradiation position to provide a singulation line 64a. FIG. 5(c) shows a case in which two singulation lines 64a are formed in parallel.

### (Formation of First Through-Hole Portions by Etching)

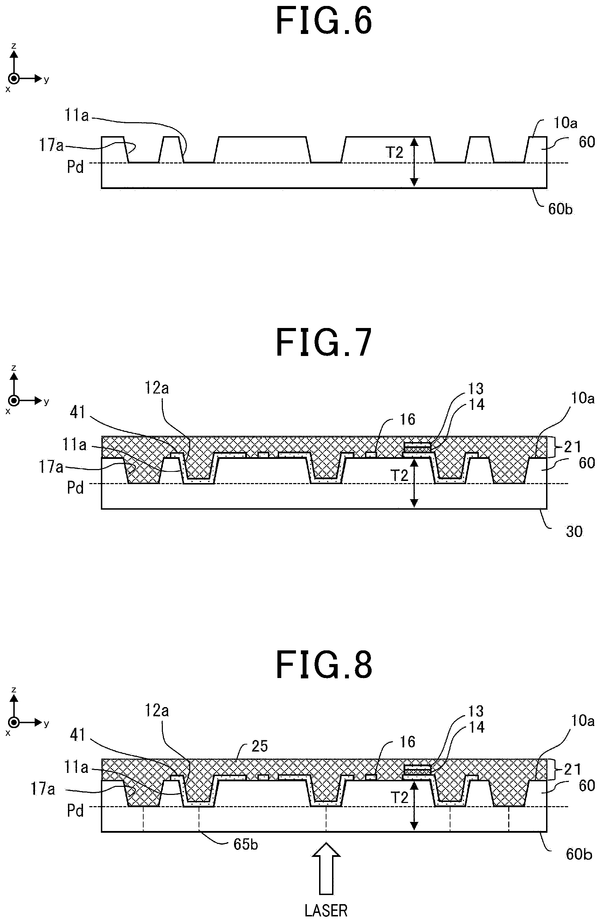

Next, a step of forming the first through-hole portions by etching (second step) will be described with reference to FIG. 6. The second step is a step of removing the first modified portions 65a by etching from the first surface 60a side to form the first through-hole portions and the first separation-groove portions. FIG. 6 is a cross-sectional view illustrating the step of forming the first through-hole portions by etching in the manufacturing method according to the first embodiment. FIG. 6 illustrates the shape of the glass substrate 60 after hydrofluoric-acid etching. By hydrofluoric-acid etching, first through-hole portions 11a and first separation-groove portions 17a described later are formed simultaneously. As illustrated here, the laser-modified portions 65a are selectively removed by etching from the first surface 60a side of the glass substrate 60. The first through-hole portions 11a are thus formed. In addition, the first surface 60a of the glass substrate 60 is etched to form a surface corresponding to the first surface 10a of the core substrate 10. For the etching, wet etching using an aqueous hydrofluoric acid solution is suitable. The amount of etching by the aqueous hydrofluoric acid solution is determined as appropriate according to the thickness of the glass multilayer wiring board. For example, if the thickness T1 of the glass substrate 60 is 1000 µm, the amount of etching is preferably in the range of 125 µm or more and 437 µm or less.

### (Formation of First Wiring Layer)

Next, a step of forming the first wiring layer 21 (a third step and a fourth step) will be described with reference to FIG. 7. The third step is a step of disposing a conductive member from the first surface side to form the first through-electrode and the first conductive portion. The fourth step is a step of depositing an insulating resin material on the first surface side to form the first wiring layer. FIG. 7 is a cross-sectional view illustrating the step of forming the first wiring layer in the manufacturing method according to the first embodiment. As shown here, by disposing a conductive member on the first surface 10a and in the first through-hole portion 11a of the glass substrate 60, the first through-electrode 12a is formed along the first through-hole portion 11a, and the through-electrode connection portion (first conductive portion) 41 is formed on the first surface 10a. In addition, by disposing the conductive member, the wiring 16 is also formed on the first surface 10a. Further, the dielectric layer 14 and the capacitor electrode 13 are also formed on the first through-electrode 12a. The first wiring layer 21 includes the through-electrode connection portion 41, the wiring 16, the dielectric layer 14, and the capacitor electrode 13.

Specifically, a seed layer is first formed on the glass substrate 60 and on the inner wall of the first through-hole portion 11a. The seed layer is a conductive metal film formed to a desired thickness. The material of the conductive metal film may be appropriately selected from, for example, Cu, Ni, Al, Ti, Cr, Mo, W, Ta, Au, Ir, Ru, Pd, Pt, AlSi, AlSiCu, AlCu, NiFe, ITO, IZO, AZO, ZnO, PZT, TiN, and Cu₃N₄.

The through-electrode connection portion 41 (electrode) and the wiring 16 are formed, for example, by a semi-additive process (SAP). In the semi-additive process, a photoresist is used to form a desired pattern. In general, a dry film resist is used, but a liquid resist may also be used. After exposure and development of the resist to form a desired pattern, an electroplated film having a thickness of 2 µm or more and 20 µm or less is formed. By stripping the resist pattern no longer needed and etching the seed layer, the wiring 16 is formed between the through-electrode connection portion 41 located above or around the first through-hole portion 11a and the first through-hole portion 11a.

From the perspectives of insulation properties and relative permittivity, the dielectric layer 14 on the through-electrode connection portion 41 is formed using at least one of alumina, silica, silicon nitride, tantalum oxide, titanium oxide, calcium titanate, barium titanate, and strontium titanate. The dielectric layer 14 preferably has a thickness in the range of 10 nm or more and 5 µm or less. If the thickness of the dielectric layer 14 is less than 10 nm, sufficient insulation cannot be maintained and the capacitor does not function properly. If the thickness of the dielectric layer 14 exceeds 5 µm, not only does the film deposition take too long, resulting in poor mass productivity, but also additional time is required in the step of removing unnecessary portions. The thickness of the dielectric layer 14 is more preferably in the range of 50 nm or more and 1 µm or less.

The capacitor electrode 13 is formed by separately forming a lower electrode layer and an upper electrode layer. The lower electrode layer is formed using at least one of Cu, Ni, Al, Cr, Mo, W, Ta, Au, Ir, Ru, Pd, Pt, AlSi, AlSiCu, AlCu, and NiFe as a material, from the perspectives of adhesion and electrical conductivity. For example, Ti is superior from the perspectives of adhesion, electrical conductivity, ease of production, and cost.

A seed metal layer is formed for the upper electrode of the capacitor electrode 13, and an electroplated layer is further formed. For the seed metal layer, at least one of Cu, Ni, Al, Ti, Cr, Mo, W, Ta, Au, Ir, Ru, Pd, Pt, AlSi, AlSiCu, AlCu, and NiFe may be used. It is preferable to use Cu to facilitate etching removal later. The seed metal layer preferably has a thickness in the range of 10 nm or more and 5 µm or less. If the seed metal layer has a thickness of less than 100 nm, energization failure may occur during the subsequent electroplating. If the seed metal layer has a thickness exceeding 5 µm, the time taken for etching removal may be long. The thickness of the seed metal layer is more preferably in the range of 100 nm or more and 500 nm or less.

Then, an electroplated layer is formed as the upper electrode of the capacitor electrode 13. Copper electroplating is simple and inexpensive and provides good electrical conductivity. Besides copper electroplating, electroplating of nickel, chromium, Pd, gold, rhodium, iridium, or the like may be used. After formation of the upper electrode, the seed metal layer is removed. Wet etching, dry etching, or the like may be selected as appropriate depending on the application.

Finally, the insulating resin layer 25 is formed. The insulating resin layer 25 is made of a thermosetting resin, and the material therefor preferably includes at least one of an epoxy resin, a polyimide resin, and a polyamide resin, includes an SiO₂ filler material, and is in a liquid form or a film form. For a liquid resin, the insulating layer can be formed by spin coating, and for a film-type resin, the insulating layer can be formed by heating and pressurizing under vacuum using a vacuum laminator. The material of the insulating resin layer 25 may be selected as appropriate depending on need. However, since filling with an SiO₂ filler material becomes difficult when using a photosensitive insulating resin material due to the need to ensure photolithography properties, the material is limited to non-photosensitive thermosetting resin.

### (Formation of Laser-Modified Portions on Second Surface)

Next, a step of forming laser-modified portions (fifth step) will be described with reference to FIG. 8. The fifth step is a step of forming second modified portions by laser irradiation from the second surface 60b side of the glass substrate 60 at a second through-hole position, which is a position where a second through-hole portion is to be formed, the second through-hole portion extending from the second surface 60b to the intermediate portion Pd of the glass substrate 60 and constituting part of a through-hole penetrating the glass substrate 60 from the first surface 60a toward the second surface 60b, and at a second singulation-line position that is a position where a second separation-groove portion is to be formed, the second separation-groove portion extending from the second surface 60b to the intermediate portion Pd of the glass substrate 60 and constituting part of the separation groove 17 for separating the multilayer wiring board 1 from the glass substrate 60. FIG. 8 is a cross-sectional view illustrating the step of forming laser-modified portions in the manufacturing method according to the first embodiment. In FIG. 8, the broken lines indicate laser-modified portions (second modified portions) 65b. As illustrated in FIG. 8, the glass substrate 60 is irradiated with laser light from the second surface 60b side to form the laser-modified portions 65b. The laser-modified portions 65b are formed at positions (second through-hole positions) corresponding to the through-holes 11 of the core substrate 10. Each laser-modified portion 65b extends, for example, in a vertical direction (z-axis direction) relative to the glass substrate 60, and reaches the vicinity of the intermediate portion Pd of the glass substrate 60.

A laser-modified portion 65b is also formed at a position (second singulation-line position) where the second separation-groove portion is to be formed, which extends from the second surface 60b to the vicinity of the intermediate portion Pd of the glass substrate 60 and constitutes part of the separation groove for separating the multilayer wiring board 1 from the glass substrate 60. The second through-hole position and the second singulation-line position are positions on the second surface 60b that are symmetrical to the first through-hole position and the first singulation-line position shown in Figs. 5(a) and 5(b), respectively, with respect to the glass substrate 60. Note that the laser-modified portions 65b may be formed using the same laser light as the one used to form the laser-modified portions 65a.

### (Bonding of First Support)

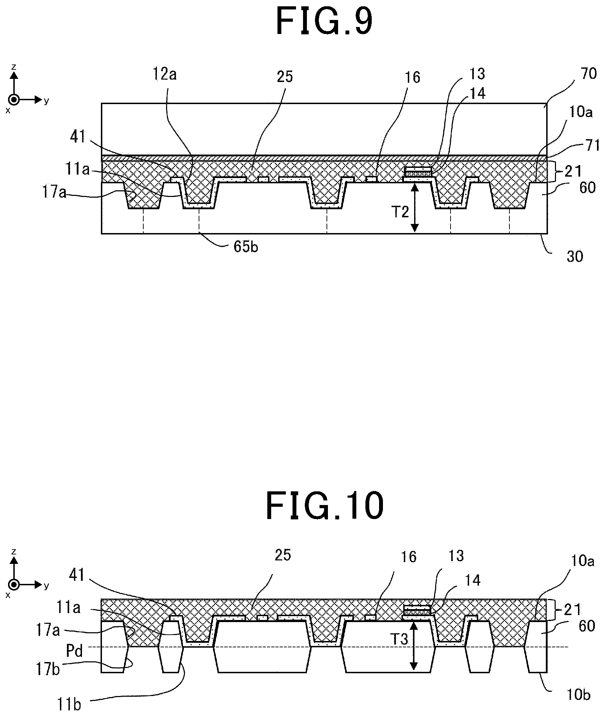

Next, a bonding step of a first support will be described with reference to FIG. 9. FIG. 9 is a cross-sectional view illustrating the bonding step of the first support in the manufacturing method according to the first embodiment. As illustrated here, a first adhesive layer 71 is formed on the first wiring layer 21 of the glass substrate 60, and a first support 70 is bonded to the first adhesive layer 71. The bonding step of the first support 70 is performed when the glass substrate 60 has a large amount of warpage that would prevent the manufacturing steps described later from being appropriately performed. In such cases, the glass substrate 60 is fixed with the first support 70 to suppress warpage, and then the manufacturing steps are carried out. Therefore, this step is not required if the manufacturing steps described later can be performed with only the glass substrate 60, and whether this step is required can be appropriately determined depending on the amount of warpage of the glass substrate 60. In the present disclosure, a case will be described in which the bonding step of the first support is not performed because the glass substrate 60 has sufficient thickness and its warpage is suppressed within a certain range.

If the bonding step of the first support is performed, the first adhesive layer 71 may be appropriately selected from resins that become detachable by absorbing light such as UV light and undergoing heat generation, sublimation, or degradation; resins that become detachable by heat-induced foaming; and functional groups that temporarily fix the glass substrate 60 and the first support 70. Furthermore, it is preferable that the first support 70 be made of the same material as the glass substrate 60. When the glass substrate 60 is alkali-free glass, it is desirable that the first support 70 also be alkali-free glass. The thickness of the first support can be appropriately set according to the thickness of the glass substrate 60. However, the thickness is preferably within a transportable range, for example, 300 µm or more and 1,500 µm or less.

### (Formation of Second Through-Hole Portions by Etching)

Next, a step of forming the second through-hole portions by etching (sixth step) will be described with reference to Figs. 10 to 15. The sixth step is a step of removing the second modified portions 65b by etching from the second surface 60b side to form the second through-hole portions and the second separation-groove portions. FIG. 10 is a cross-sectional view illustrating the step of forming the second through-hole portions by etching in the manufacturing method according to the first embodiment. FIG. 10 illustrates the shape of the glass substrate 60 after hydrofluoric-acid etching. By hydrofluoric-acid etching, the second through-hole portions 11b and the second separation-groove portions 17b are formed simultaneously. In each second through-hole portion 11b, the through-electrode 12 formed in the first through-hole portion 11a is exposed in the negative z-axis direction, and in each second separation-groove portion 17b, the insulating resin layer 25 is exposed in the negative z-axis direction. Furthermore, the second through-hole portions 11b and the second separation-groove portions 17b extend to the intermediate portion Pd. As illustrated here, the laser-modified portions 65b are selectively removed by etching from the second surface 60b side of the glass substrate 60. The second through-hole portions 11b are thus formed. In addition, the second surface 60b of the glass substrate 60 is etched to form a surface corresponding to the second surface 10b of the core substrate 10. For the etching, wet etching using an aqueous hydrofluoric acid solution is suitable. The amount of etching by the aqueous hydrofluoric acid solution is determined as appropriate according to the thickness of the glass multilayer wiring board. For example, if a thickness T2 of the glass substrate 60 is 1000 µm, the amount of etching is preferably in the range of 125 µm or more and 437 µm or less. Here, a structure is shown in which the insulating resin layer 25 is exposed at the intermediate portion of the second separation-groove portions 17b. However, the structure is not limited to this. If a seed layer of the first wiring layer 21 remains in first separation groove-portions 17a, the seed layer of the first wiring layer 21 will be exposed in the second separation-groove portion 17b.

The glass substrate 60 is also etched along with the etching of the laser-modified portions 65. The thickness T3 of the glass substrate 60 after etching is preferably within the range of 150 µm or more and 2,000 µm or less.

In conventional methods for manufacturing multilayer wiring boards, after forming separation grooves along the singulation lines, it is necessary to attach the core substrate portions to a support to prevent them from separating, resulting in an increase in the number of manufacturing steps and manufacturing costs, such as the cost of the support. In the first embodiment, even when the second separation-groove portions 17b are formed, the insulating resin layer 25 remains embedded in the first separation-groove portions 17a. Since the insulating resin layer 25 bonds the sidewalls of the core substrate portions together, separation of the core substrate portions can be suppressed, eliminating the need to attach the core substrate portions to a support and suppressing increases in manufacturing steps and manufacturing costs.

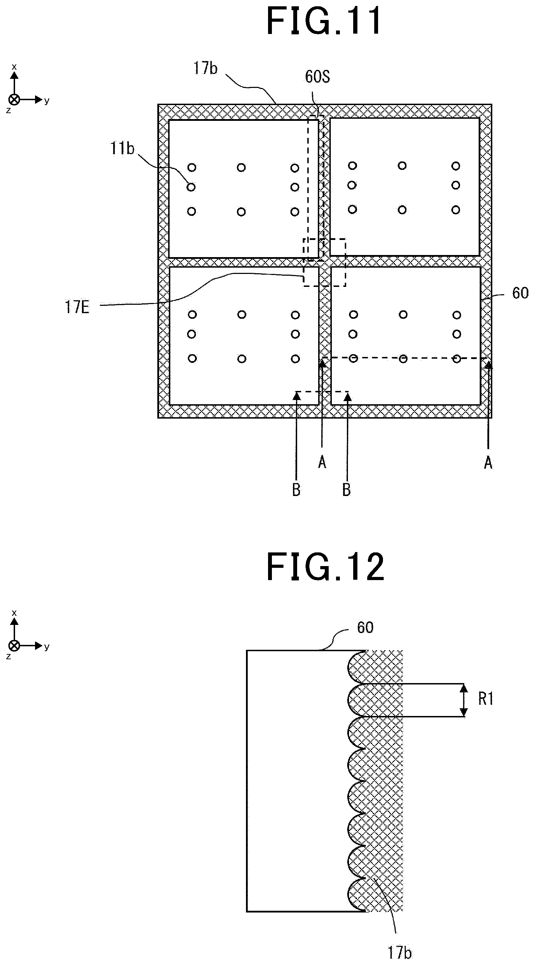

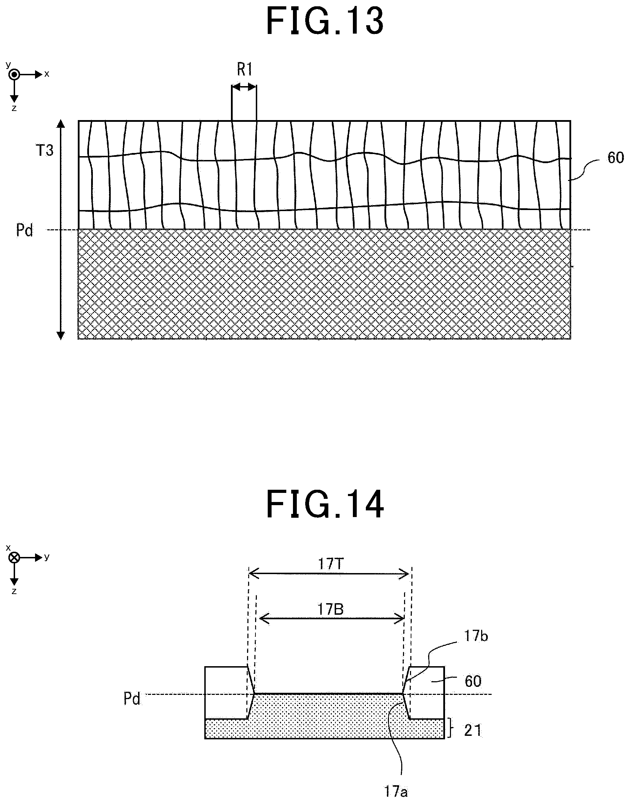

Next, FIG. 11 is a bottom view of the glass substrate 60 after the second separation-groove portions 17b are formed. FIG. 12 is a schematic enlarged view of a portion of the second separation-groove portion. FIG. 12 illustrates a portion of an area 60S in FIG. 11. FIG. 13 is a schematic diagram showing side surfaces of the first and second separation-groove portions 17a and 17b. FIG. 13 schematically shows the area 60S in FIG. 11 as viewed from the second surface 10b side (i.e., viewing the glass substrate 60 from the side). FIG. 13 can be obtained, for example, by a scanning electron microscope (SEM). As illustrated in FIG. 12, vertical ridges are formed on the side surface of the glass substrate 60, constituted by convex portions extending in the normal direction (z-axis direction) of the glass substrate 60 and arranged in series along the xy-plane direction following the processing pitch of the laser-modified portions 65b for forming the second separation-groove portion 17b. Furthermore, the solid lines shown in FIG. 13 indicate uneven ridges constituted by the vertical ridges and horizontal ridges substantially perpendicular to the vertical ridges formed on the side surface of the glass substrate 60. Consequently, numerous substantially rectangular recesses are formed on the side surface of the glass substrate 60. The dimensions of these rectangles are such that, for example, when the laser-modified portions 65b are processed at a pitch of 10 µm, an interval R1 of the ridges formed in the second separation-groove portion 17b shown in FIG. 12 or the interval R1 of the ridges shown in FIG. 13 is 10 µm or less. The processing pitch of the laser-modified portions 65b can be set as desired according to the ridge interval R1. Furthermore, in the second separation-groove portion 17b shown in FIG. 12, the width of the peaks and valleys formed along the ridges (hereinafter also referred to as the "peak to valley (PV) of the ridges), in other words, the distance between a convex portion and a concave portion in the Y-axis direction is approximately 10 µm or less. Although the second separation-groove portions 17b have been described above, if the insulating resin layer 25 were removed to expose the first separation-groove portions 17a, the above description could also be applied to the first separation-groove portions 17a.

Furthermore, as illustrated in FIG. 13, the side surface 10c of the core substrate 10 has a plurality of substantially rectangular recesses formed by a plurality of vertical ridges and horizontal ridge, and the horizontal dimension of the substantially rectangular shape may, for example, be in the range of 5 µm or more and 20 µm or less, the longitudinal dimension may be in the range of 2 µm or more and 25 µm or less, and the depth of the recesses may be in the range of 0.5 µm or more and 11 µm or less.

The asperities on the surfaces of the glass substrate 60 where the first separation-groove portion 17a and second separation-groove portion 17b are formed are minute and have the effect of improving adhesion between the glass substrate 60 and the insulating resin layers 25 of the first wiring layer 21 and the second wiring layer 22 described later. Note that FIG. 10 is a cross-sectional view taken along line A-A of FIG. 11.

FIG. 14 is a schematic enlarged view of the separation-groove portion 17. FIG. 14 is a cross-sectional view taken along line B-B of FIG. 11. In the separation groove 17, as illustrated in FIG. 14, the ratio of a processing width 17B at the intermediate portion Pd to an opening width 17T of the opening on the first surface 10a or second surface 10b side (processing width 17B / opening width 17T) can be set within the range of 0.85 or more and 1.0 or less by changing the pitch interval and number of laser-modified portions. By choosing a desired width that satisfies the above range for the processing width 17B at the intermediate portion Pd of the separation groove 17, the amount of insulating resin material placed on the inclined portion of the separation groove 17 can be adjusted, thereby facilitating achieving a desired thickness for the insulating resin portion 24 covering the side surface of the multilayer wiring board after singulation.

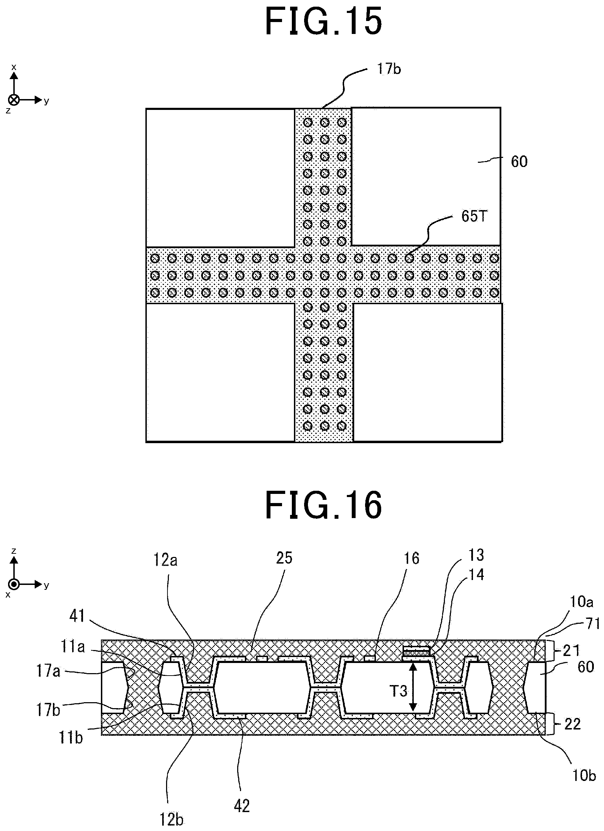

FIG. 15 is a schematic enlarged view of a portion of a bottom view of the separation grooves 17. FIG. 15 shows a region 17E in FIG. 11. The insulating resin layer 25 exposed within the separation grooves 17 has transfer marks 65T of the laser-modified portions 65b, which form minute asperities. These asperities produce an anchoring effect during subsequent wiring formation and when forming the insulating resin layer 25 of the second wiring layer 22. As a result, the insulating resin layer 25 is integrally formed between the first wiring layer 21 and the second wiring layer 22, improving adhesion between the insulating resin layer 25 and the core substrate 10 in the multilayer wiring board 1.

### (Formation of Second Wiring Layer)

Next, a step of forming the second wiring layer (a seventh step and an eighth step) will be described with reference to FIG. 16. The seventh step is a step of disposing a conductive member from the second surface 60b side to form the second through-electrode and the second conductive portion. The eighth step is a step of depositing a resin material on the second surface 60b side to form the second wiring layer. FIG. 16 is a cross-sectional view illustrating the step of forming the second wiring layer in the manufacturing method according to the first embodiment. As illustrated here, the second wiring layer 22 including the second through-electrodes 12b, the through-electrode connection portions 42, and the insulating resin layer 25 is formed on the second surface 10b of the glass substrate 60. To form the second through-electrodes 12b and the through-electrode connection portions 42, a seed layer for power supply is formed, patterning is performed using a resist, and plating is performed to form a plating layer with a thickness of 2 µm or more and 20 µm or less. Subsequently, the resist pattern no longer needed is stripped, the seed layer is removed, and the second through-electrodes 12b and the through-electrode connection portions 42 are formed.

Here, in a case where the seed layer is formed using a dry method such as sputtering, if the thickness of the core substrate 10 becomes large, the coverage of the seed layer in the through-holes 11 during formation of through-electrodes in the core substrate 10 decreases, making it difficult to ensure the reliability of the multilayer wiring board. In the first embodiment, since the second through-electrodes 12b extend to the intermediate portion Pd of the glass substrate 60, the thickness of the core substrate 10 on which the seed layer is formed is effectively halved. As a result, the coverage of the seed layer is improved compared to forming the seed layer on the sidewalls of through-holes through the thickness of the core substrate 10, thereby ensuring the reliability of the multilayer wiring board 1.

Furthermore, in the step of forming the through-electrodes 12 by plating, in a case where each through-electrode 12 is formed by providing only a conductive layer inside the through-hole 11, if the thickness of the core substrate 10 becomes large, the filling capability of the plating film into the through-hole 11 during the plating process decreases. This prevents complete formation of a conductor layer entirely covering the interior of the through-hole 11, making it difficult to ensure the reliability of the multilayer wiring board 1. In the first embodiment, since the conductor layer of each first through-electrode 12a extends to the intermediate portion Pd of the through-hole 11, the thickness of the core substrate 10 in which the conductor layer is formed is effectively halved, improving the filling capability of the plating film compared to forming the conductor layer in a through-hole having a depth equal to the thickness of the core substrate 10. Consequently, the conductor layer can be formed throughout the interior of the through-hole 11 with good filling capability, ensuring the reliability of the multilayer wiring board. The above description pertains to the second through-electrodes 12b, but a similar description can also be made for the first through-electrodes 12a.

Finally, the insulating resin layer 25 is formed, completing the second wiring layer 22. Although the insulating resin layers 25 formed in the first wiring layer 21 and the second wiring layer 22 are assumed to be formed from the same material in the example shown here, it is not limited thereto. The insulating resin layers may be formed from different materials. The portions of the through-holes 11 that did not become the through-electrodes 12 become the separation grooves 17. The separation grooves 17 are also filled with the insulating resin layers 25.

During the process of filling the separation grooves 17 with the insulating resin layers 25, if the thickness of the core substrate 10 becomes large, the embedding of the insulating resin layers 25 into the separation grooves 17 deteriorates, leading to the formation of voids. The voids prevent the insulating resin layers 25 from being sufficiently formed over the entire sidewall surface of the core substrate, making it difficult to avoid damage to the core substrate. In the first embodiment, since the insulating resin layers 25 extend to the central portion of the separation groove 17 (a position near the intermediate portion Pd), the thickness of the core substrate 10 that each insulating resin layer 25 needs to fill is effectively halved. Consequently, the embedding is improved compared to filling the insulating resin layer 25 into separation grooves 17 extending through the full thickness of the core substrate 10, thereby suppressing void formation, allowing the insulating resin layers 25 to cover the entire sidewall of the core substrate, and making it possible to avoid damage to the core substrate 10.

### (Removal of the First Support)

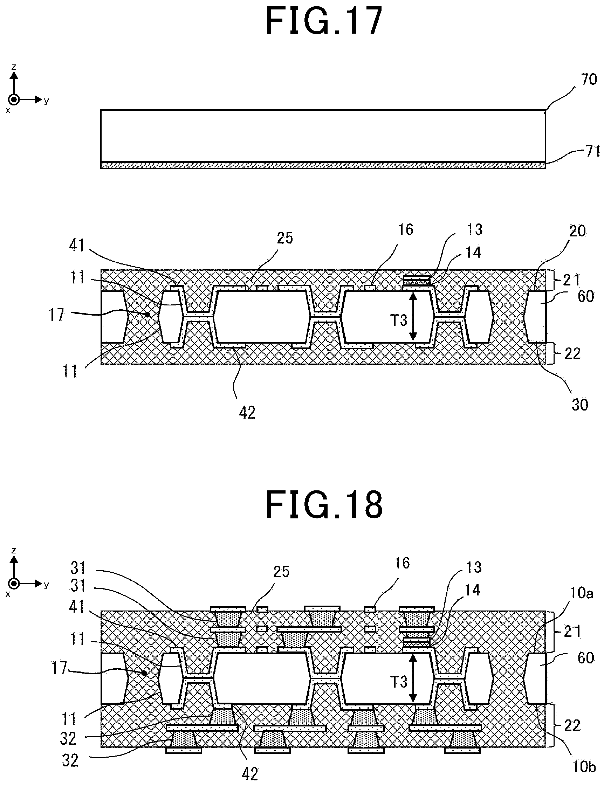

Next, a removing step of the first support 70 will be described with reference to FIG. 17. If the bonding step of the first support 70 shown in FIG. 9 had been performed, the removal step of the first support 70 would be carried out after the step of forming the second wiring layer. FIG. 17 is a diagram illustrating the removal step of the first support 70 in the manufacturing method according to the first embodiment. As shown in FIG. 17, the interface between the first wiring layer 21 and the first support 70 is separated so that the first support 70 and the first adhesive layer 71 are detached. As a result, as illustrated in FIG. 16, a glass substrate 60 is obtained in which the first wiring layer 21 is formed on the first surface 10a side of the glass substrate 60 and the second wiring layer 22 is formed on the second surface 10b side.

When separating the first support 70 from the first wiring layer 21, an appropriate removal method can be selected according to the material of the first adhesive layer 71, such as UV light irradiation, heat treatment, or physical peeling. Furthermore, if residue of the first adhesive layer 71 remains on the bonding surface between the first wiring layer 21 and the first adhesive layer 71, plasma cleaning, ultrasonic cleaning, water washing, or solvent cleaning using alcohol may be performed.

### (Formation of Build-up Layer)

Next, referring to FIG. 18, a step of forming a build-up layer, that is, a laminated layer including the first wiring layer 21 and the second wiring layer 22, will be described. FIG. 18 is a diagram illustrating the step of forming the build-up layer in the manufacturing method according to the first embodiment.

As shown in FIG. 18, the conductive electrodes 31 for electrically connecting the first wiring layer 21 on the first surface 10a side, and the conductive electrodes 32 for electrically connecting the second wiring layer 22 on the second surface 10b side, are formed on the first wiring layer 21 on the first surface 10a side of the glass substrate 60 and on the second wiring layer 22 on the second surface 10b side. The conductive electrodes 31 and 32 are formed by first forming vias in the insulating resin layers 25 using laser light, then forming a seed layer in the vias, and subsequently employing a semi-additive process (i.e., a series of processes including resist pattern formation, plating, resist stripping, seed layer removal, and insulating resin layer formation).

The first wiring layer 21 and the second wiring layer 22 each include at least one laminated layer, and the number of layers can be set depending on need. In FIG. 18, both the first wiring layer 21 and the second wiring layer 22 include two laminated layers.

The laser light used to form the conductive electrodes 31 and 32 may be different from that used to form the laser-modified portions 65. For example, it is desirable to use a pulsed laser such as a carbon dioxide laser or a UV-YAG laser, and a laser with a pulse width on the order of microseconds is suitable.

### (Formation of Connection Pads)

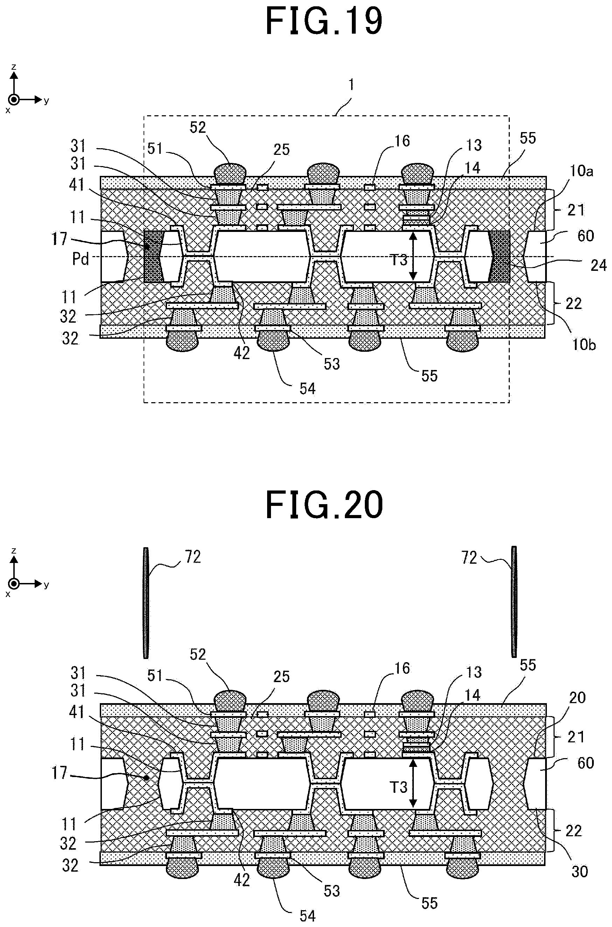

Next, the formation of connection pads will be described with reference to FIG. 19. FIG. 19 is a diagram illustrating the step of forming the connection pads in the manufacturing method according to the first embodiment. As shown here, after forming an outer protective film such as solder resist 55 on the first wiring layer 21 and the second wiring layer 22, semiconductor device bonding pads 51 are formed on the first wiring layer 21, and substrate bonding pads 53 are formed on the second wiring layer 22. Surface treatments such as Ni/Au, Ni/Pd/Au, IT, or OSP (watersoluble preflux) are applied to the semiconductor device bonding pads 51 and the substrate bonding pads 53, and if necessary, the semiconductor device bonding solder 52 and substrate bonding solder 54 are formed to complete the multilayer wiring board. Note that Ni/Au refers to the use of both Ni and Au, and Ni/Pd/Au refers to the use of Ni, Pd, and Au together.

The structure shown in FIG. 19 may also be considered an intermediate product of the multilayer wiring board 1, namely a multilayer wiring base substrate. Specifically, the multilayer wiring base substrate includes: the glass substrate 60 having the first surface 10a and the second surface 10b; at least one first wiring layer region including a wiring layer (first wiring layer 21) formed on the first surface 10a; at least one second wiring layer region including a wiring layer (second wiring layer 22) formed on the second surface 10b; the separation groove 17 extending from the first surface 10a to the second surface 10b to singulate at least one multilayer wiring board 1 including the first and second wiring layer regions; and the insulating resin portion 24 disposed in the separation groove 17 to bond adjacent multilayer wiring boards together; wherein the width of the separation groove 17 decreases from the first surface 10a toward the intermediate portion Pd of the glass substrate 60 and increases from the intermediate portion Pd toward the second surface 10b. In the xy-plane, the multilayer wiring board 1 has a rectangular shape, as shown for example in Figs. 5 and 11, and the first wiring layer region and the second wiring layer region are regions having the same rectangular shape as the multilayer wiring board 1.

### (Singulation)

Next, a step of singulating the multilayer wiring boards (ninth step) will be described with reference to FIG. 20. The ninth step is a step of singulating along the separation grooves 17 to separate the multilayer wiring boards 1. FIG. 20 is a cross-sectional view illustrating the singulation step in the manufacturing method according to the first embodiment. As shown in FIG. 20, the singulation of the multilayer wiring boards is performed along the singulation lines formed by laser light and hydrofluoric-acid etching. FIG. 20 shows a case where blade dicing using a blade 72 is assumed, but methods other than blade dicing, such as laser and scribing, may also be used. Singulation may also be performed by combining blade dicing, laser, and scribing.

### (Flowchart of the Manufacturing Method According to First Embodiment)

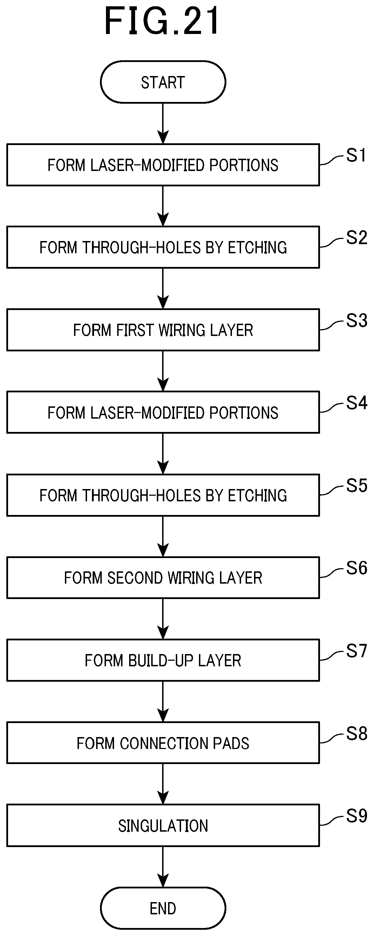

The steps described above are summarized in a flowchart. FIG. 21 illustrates a flowchart of the manufacturing method according to the first embodiment.

Step S1 is the step of forming the laser-modified portions 65a. The laser-modified portions 65a serve as the starting point for the through-holes and separation grooves. Each laser-modified portion 65a is formed by laser irradiation from the first surface 60a side of the glass substrate 60, and extends to the central portion (e.g., the intermediate portion Pd) of the glass substrate 60.

Step S2 is the step of forming the first through-hole portions 11a by etching. The first through-hole portion 11a is formed so as to extend to the central portion (e.g., the intermediate portion Pd) of the glass substrate 60. The portions where the laser-modified portions 65a are removed become the first through-hole portions 11a or the first separation-groove portions 17a.

Step S3 is the step of forming the first wiring layer 21. The first through-electrodes 12a are formed in the first through-hole portions 11a of the glass substrate 60, and electrodes and wiring electrically connected to the first through-electrodes 12a are formed.
Electrodes, wiring, capacitors, inductors, or the like can be formed in the first wiring layer 21.

Step S4 is the step of forming the laser-modified portions 65b. Each laser-modified portion 65b is formed by laser irradiation from the second surface 60b side of the glass substrate 60, and extends to the central portion (e.g., the intermediate portion Pd) of the glass substrate 60.

Step S5 is the step of forming the second through-hole portions 11b by etching. The portions where the modified portions are removed become the second through-hole portions 11b or the second separation-groove portions 17b.

Step S6 is the step of forming the second wiring layer 22. The second through-electrodes 12b are formed in the second through-hole portions 11b of the glass substrate 60, and electrodes and wiring electrically connected to the second through-electrodes 12b are formed.

Step S7 is the step of forming the build-up layer. Electrodes and wiring are formed on the first wiring layer 21 and the second wiring layer 22.

Step S8 is the step of forming the connection pads. Protective films are formed on the first wiring layer 21 and the second wiring layer 22, and then connection pads are formed.

Step S9 is the singulation step. Dicing or the like is performed on the glass substrate 60 to separate the multilayer wiring boards 1.

### <First Modification>

Next, a manufacturing method as a first modification will be described with reference to Figs. 21 to 24.

The first modification differs from the first embodiment in that the laser-modified portions are formed in a single operation from the first surface 60a side to the second surface 60b side of the glass substrate 60 during the laser-modified portion formation step.

In the following description, components that are the same as or similar to those of the first embodiment are given the same reference signs, and will not be described in detail or at all.

### (Formation of Laser-Modified Portions)

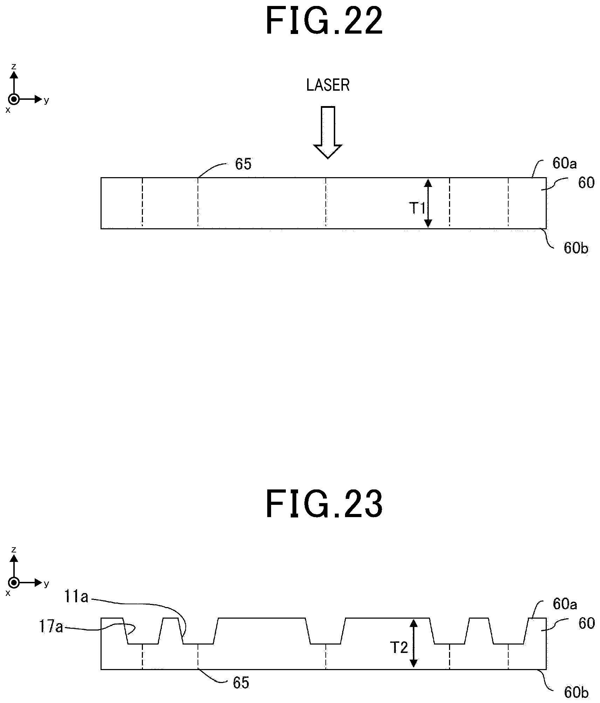

Referring to FIG. 22, the laser-modified portion formation step in the first modification will be described. FIG. 22 is a cross-sectional view illustrating the step of forming laser-modified portions in the manufacturing method according to the first modification. As shown here, laser irradiation is performed from the first surface 60a side to form laser-modified portions 65 extending from the first surface 60a side to the second surface 60b side.

Since laser-modified portions 65 are also formed along the singulation lines of the multilayer wiring board 1 in this step, it is possible to obtain the same side surface shape as that of the multilayer wiring board 1 described in the first embodiment.

### (Formation of Through-Holes by Etching)

Next, a step of forming through-holes by etching will be described with reference to FIG. 23. FIG. 23 is a cross-sectional view illustrating the step of forming through-holes by etching in the manufacturing method according to the first modification. FIG. 23 illustrates the shape of the glass substrate 60 after hydrofluoric-acid etching. By appropriately adjusting the concentration and processing time of the hydrofluoric-acid etching, the first through-hole portions 11a and the first separation-groove portions 17a extending from the first surface 60a side of the glass substrate 60 to the intermediate portion Pd are simultaneously formed. The portion of each laser-modified portion 65 from the intermediate portion Pd to the second surface 60b side of the glass substrate 60 remains. As illustrated here, the laser-modified portions 65 are selectively removed by etching from the first surface 60a side of the glass substrate 60. The first through-hole portions 11a are thus formed. For the etching, wet etching using an aqueous hydrofluoric acid solution is suitable.

### (Steps Following Formation of the First Wiring Layer)

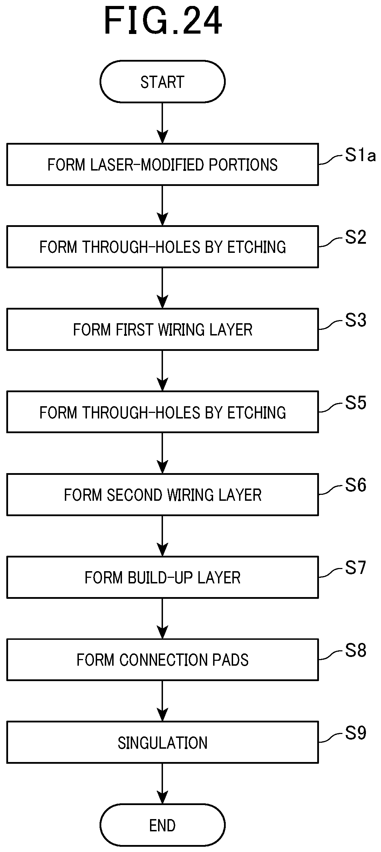

FIG. 24 illustrates a flowchart of a manufacturing method according to the first modification. In the first embodiment, as illustrated in FIG. 21, after the laser-modified portion forming step (step S1) and the step of forming through-holes by etching (step S2), the first wiring layer forming step (step S3) of the first embodiment shown in FIG. 7 is performed.

On the other hand, in the first modification, as illustrated in FIG. 22, laser-modified portions 65 are also formed on the second surface 60b side in the laser-modified portion forming step (corresponding to step S1a in FIG. 24). Accordingly, in the flowchart of the first modification shown in FIG. 24, the steps up to the step of forming through-holes by etching (step S2) and the first wiring layer forming step (step S3) are the same as steps S2 and S3 of the first embodiment shown in FIG. 21, but the second step of forming laser-modified portions (step S4) shown in FIG. 21 can be omitted. The steps from the step of forming through-holes by etching (step S5) onward shown in FIG. 24 (steps S5 to S9) are the same as steps S5 to S9 of the manufacturing method according to the first embodiment shown in FIG. 21.

### <Advantageous Effects>

According to the first embodiment and the first modification of the present invention, even when the core substrate is thick, damage to the core substrate can be avoided by protecting the side surface of the core substrate of the multilayer wiring board, thereby ensuring the reliability of the multilayer wiring board. In addition, it is possible to reduce the manufacturing steps and the manufacturing cost of the multilayer wiring board. Details will be described below with reference to Examples and Comparative Examples. Each of the Examples described below is merely an example for implementing the present invention, and the present invention should not be construed as being limited to these embodiments.

### <Examples and Comparative Examples According to First Embodiment and First Modification>

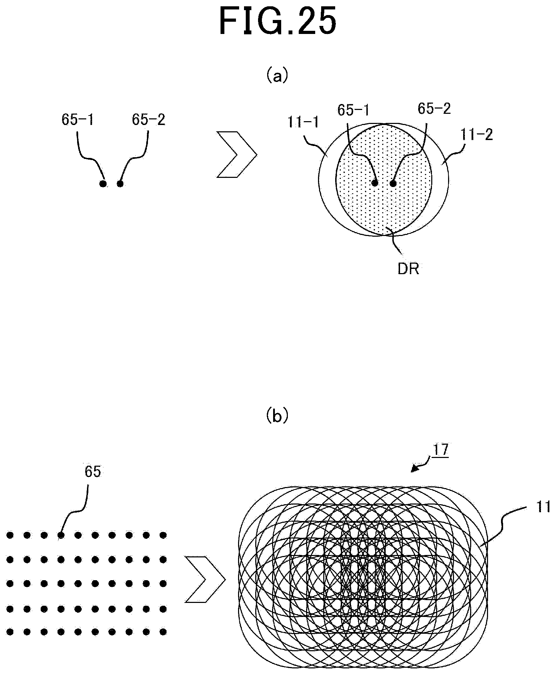

The Examples and Comparative Examples were prepared so as to differ in whether the insulating resin portion 24 was present on the side surface 10c of the core substrate 10 of the multilayer wiring board 1, and were subjected to a temperature cycling test. Table 1 shows the manufacturing conditions, the overlap ratio of through-holes, ridge interval, and the like for the Examples and Comparative Examples. In Examples 1 to 3, the processing pitch of the laser-modified portions was varied so that the overlap ratio of the through-holes 11 formed in the glass substrate 60 by hydrofluoric-acid etching was 40%, 65%, and 90%, respectively. FIG. 25 is a diagram for explaining the overlap ratio of the laser-modified portions 65 and the through-holes 11. As shown in FIG. 25, the overlap ratio indicates the ratio of overlap between a through-hole 11 and an adjacent through-hole 11 when the laser-modified portions 65 are etched with hydrofluoric acid to form the through-holes 11. The higher the overlap ratio, the greater the ratio of overlap between adjacent through-holes 11. FIG. 25(a) shows a case where two laser-modified portions are provided, and FIG. 25(b) shows a case where a separation groove is formed by providing a plurality of laser-modified portions. As shown in FIG. 25(a), in the separation groove 17, a through-hole 11-1 is formed in a laser-modified portion 65-1, and a through-hole 11-2 is formed in a laser-modified portion 65-2. The overlapping region between the through-holes 11-1 and 11-2 is denoted as DR. The overlap ratio is the size of the overlapping region DR relative to the size of the through-hole 11-1 or 11-2. As shown in FIG. 25(b), the separation groove 17 is formed by forming a plurality of laser-modified portions 65 and through-holes 11.

Examples 1 to 3 correspond to the multilayer wiring board 1 shown in FIG. 1. In Comparative Example 1, the processing pitch of the laser-modified portions in the separation groove 17 was set to a larger value than in Examples 1 to 3, and processing was performed so that the overlap ratio of the through-holes 11 formed by hydrofluoric-acid etching was 30%. In Comparative Example 2, multilayer wiring boards were fabricated without forming the separation groove 17, and dicing was performed after fabrication to singulate the boards. Table 1 shows the Examples and Comparative Examples. Table 1 shows, for each Example and Comparative Example, the average ridge interval and the average PV, the average value and variation of the upper opening width of the separation groove when processed such that the upper opening width of the separation groove is 300 µm, the average value and variation of the intermediate processing width, the average value of the intermediate processing width/upper opening width, and the average resin thickness on the side surface of the core substrate. As one example of the measurement method, after hydrofluoric-acid etching or singulation, the side surface and upper surface of the core substrate were observed using a scanning electron microscope (SEM). Characteristic values were measured at selected locations with a sample size of n ≥ 20, and average values were calculated. Here, the ridge interval refers to the ridges formed in a vertical direction with respect to the first surface 10a and the second surface 10b of the glass substrate 60. From Table 1, it can be understood that as the overlap ratio decreases, the ridge interval increases.

**[Table 1]**

| | | Example 1 | Example 2 | Example 3 | Comp. Ex. 1 | Comp. Ex. 2 |
|---|---|---|---|---|---|---|
| Separation groove | | Present | | | | Absent |
| Separation groove formation method | | Laser modification + hydrofluoric-acid etching | | | | |
| Overlap ratio | | 40% | 65% | 90% | 30% | - |
| Ridge interval (avg.) | | 43.2 µm | 25.2 µm | 7.2 µm | 50.4 µm | - |
| Ridge PV (avg.) | | 10.6 µm | 6.1 µm | 1.8 µm | 12.6 µm | < 0.1 µm |
| Opening width | Avg. | 290.4 µm | 293.1 µm | 296.3 µm | 283.2 µm | - |
| | Variation | 8.64 | 4.56 | 2.16 | 12.36 | |
| Intermediate portion width | Avg. | 255.6 µm | 260.9 µm | 266.5 µm | 221.2 µm | |
| | Variation | 10.2 | 5.4 | 2.28 | 14.88 | |
| Processing width of intermediate portion / opening width (avg.) | | 0.88 | 0.89 | 0.9 | 0.78 | |
| Thickness of resin on core substrate side surface (avg.) | | 52.8 µm | 55.5 µm | 58.9 µm | 35.6 µm | 0 µm |
| TCT test -55°C to 125°C | 0 cyc. | Passed | Passed | Passed | Passed | Passed |
| | 50 cyc. | | | | | |
| | 100 cyc. | | | | | Failed |
| | 500 cyc. | | | | | |
| | 600 cyc. | | | | Failed | |
| | 1000 cyc. | | | | | |

Next, the upper opening width of the separation groove (the opening width of the opening on the first surface side or the opening width of the opening on the second surface side), the intermediate processing width (the opening width of the opening at the intermediate portion Pd), and the PV of the ridges of each Example and Comparative Example will be described with reference to Table 1. As described above, processing was performed such that the upper opening width of the separation groove would be 300 µm. From Table 1, it can be seen that as the overlap ratio decreases and the ridge interval increases, the average processing width at the intermediate portion Pd decreases and the variation (standard deviation) σ increases. Further, it was confirmed that as the overlap ratio decreases and the ridge interval increases, the PV of the ridges increases and the side surfaces of the separation groove become rougher. These results suggest that setting a lower overlap ratio and a larger ridge interval makes the side surfaces of the separation groove rougher, thereby reducing smoothness of the side surfaces of the separation groove.

Next, results of the temperature cycling test will be described. In general, microcracks tend to occur due to accumulation of stress, particularly when the difference in linear expansion coefficient between a glass substrate and a wiring layer is large or when temperature changes are large. Therefore, in the present disclosure, a temperature cycling test was used in particular to evaluate the quality of the multilayer wiring board. As shown in Table 1, Comparative Example 1 passed the temperature cycling test up to 500 cycles, but failed after 600 cycles. Comparative Example 2 failed the temperature cycling test after 50 cycles. In cases of failure, defects such as occurrence of microcracks were confirmed. Examples 1, 2, and 3 passed the temperature cycling test even at 1000 cycles. In Comparative Example 1, the separation grooves were formed similarly to Examples 1 to 3, but, as shown in Table 1, the PV of the ridges was large. It can be considered that, for example, when singulation was performed by dicing along the separation grooves, the dicing blade partially contacted the glass substrate 60, generating grinding marks, that is, microcracks on the glass substrate 60 and causing the sample to fail the temperature cycling test.

The dicing along the separation grooves, the temperature cycling test conditions, and the evaluation method are as follows.

### <Dicing>

Blade used: R07-SD600-BB200-75 54 × 0.15A2 × 40
Equipment used: DAD322

### <Temperature Cycling Test>

Test conditions: One cycle consists of temperature changes through -55°C, room temperature (RT), and 125°C, with each temperature held for 30 minutes, and the test is performed for up to 1000 cycles.
Observation method: The side surface of the substrate is observed with a metallurgical microscope at 100× and 500× magnification to evaluate whether the glass substrate is damaged.

From the above Examples, regarding the through-holes in the separation grooves, it is more preferable that the overlap ratio be within the range of 40% or more and 90% or less, the thickness of the insulating resin portion 24 on the side surface 10c of the core substrate 10 be 52.8 µm or more, the processing width at the intermediate portion/opening width be 0.88 or more; and the PV of the vertical or horizontal ridges be within the range of 1.8 µm or more and 10.6 µm or less.

### <Second Embodiment>

The second embodiment differs from the first embodiment in that an inductor is formed in the first wiring layer.

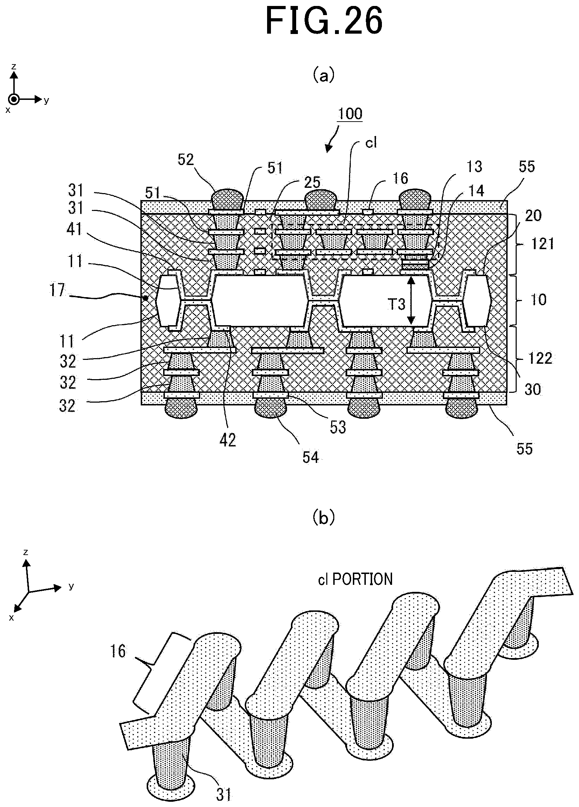

FIG. 26 is a cross-sectional view illustrating a multilayer wiring board 100 according to the second embodiment. FIG. 26(a) shows a cross-sectional view of the entire multilayer wiring board 100, and FIG. 26(b) is a perspective view of a circuit element located in a portion cl enclosed by a dot-dashed line in FIG. 26(a). In the following description, components that are the same as or similar to those of the first embodiment are given the same reference signs, and will not be described in detail or at all.

As shown in FIG. 26(a), the first wiring layer 121 includes three wiring layers, and the second wiring layer 122 also includes three wiring layers. Furthermore, as illustrated in FIG. 26(b), adjacent conductive electrodes 31 are connected via the wiring 16, forming a coil together. The coil is connected to, for example, the capacitor electrode 13 to function as an LC circuit.

As for the manufacturing method, in the step of forming the first wiring layer, the arrangement of the conductive electrodes 31 and the wiring 16 is configured to form the inductor.

### <Advantageous Effects>

Even when the core substrate is thick, damage to the core substrate can be prevented by protecting the side surface of the core substrate 10 of the multilayer wiring board with insulating resin, thereby ensuring the reliability of the multilayer wiring board. In addition, it is possible to reduce the manufacturing steps and the manufacturing cost of the multilayer wiring board. Additionally, since an inductor is provided within the multilayer wiring board 100, the wiring distance can be reduced, and favorable transmission characteristics can be obtained.

### <Third Embodiment>

The third embodiment differs from the first embodiment in that the interior of each through-electrode 12 is filled with a conductive member.

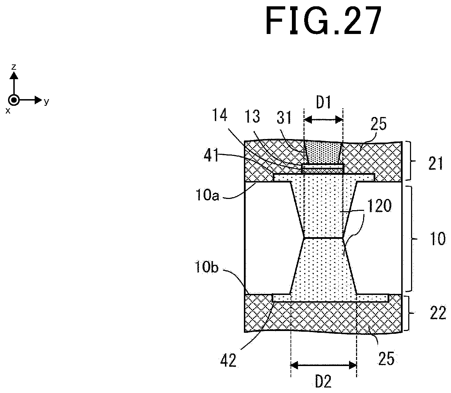

FIG. 27 is a cross-sectional view illustrating an enlarged view of the structure of a through-electrode in the multilayer wiring board according to the third embodiment. In the following description, components that are the same as or similar to those of the first embodiment are given the same reference signs, and will not be described in detail or at all.

The through-electrode 120 is filled with a conductive member. The capacitor electrode 13 is positioned above the through-electrode 120.

### <Advantageous Effects>

By adopting a structure in which the through-electrode 120 is filled with a conductive member, the capacitor electrode 13 can be formed near or above the through-hole, in other words, without being restricted by the position of the through-hole. As in the third embodiment, it is also possible to provide the capacitor electrode 13 directly above the through-hole. This allows the transmission distance to the capacitor to be shortened, thereby avoiding degradation of transmission characteristics. Furthermore, by forming a lower electrode layer when forming the capacitor electrode 13, it is possible to reduce variation in the capacitance of the capacitor.

### <Fourth Embodiment>

The fourth embodiment differs from the first embodiment in that a hydrofluoric acid-resistant metal layer is used.

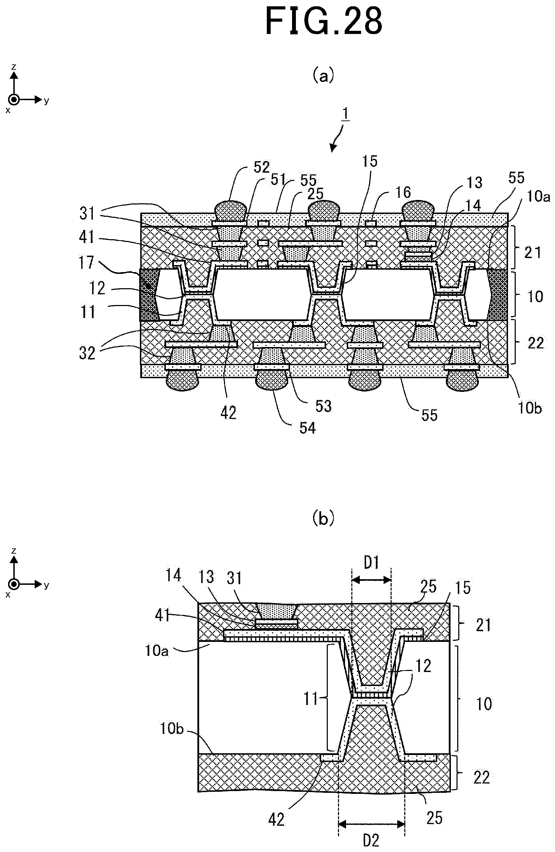

FIG. 28 is a cross-sectional view illustrating a multilayer wiring board according to the fourth embodiment. FIG. 28(a) shows a cross-sectional view of the entire multilayer wiring board, and FIG. 28(b) is an enlarged cross-sectional view showing the structure of the through-electrode. In the following description, components that are the same as or similar to those of the first embodiment are given the same reference signs, and will not be described in detail or at all.

A hydrofluoric acid-resistant metal layer 15 is provided on the glass substrate 60 and between the inner wall of the through-hole 11 and the seed layer. The hydrofluoric acid-resistant metal layer 15 is a metal layer containing at least one of chromium or nickel, and is formed by sputtering to a thickness in the range of 10 nm or more and 1,000 nm or less. When the hydrofluoric acid-resistant metal layer 15 is used, the hydrofluoric acid-resistant metal layer 15 is exposed in addition to the insulating resin layer 25 shown in FIG. 15.

### <Advantageous Effects>

When forming the second through-hole portion 11b shown in FIG. 10 by hydrofluoric-acid etching, it is necessary to appropriately control the etching amount so that etching stops at the intermediate portion of the glass substrate 60. Meanwhile, in the fourth embodiment, since the hydrofluoric acid-resistant metal layer 15 is provided, etching stops at the hydrofluoric acid-resistant metal layer 15, making it possible to form a through-hole with the desired X-shape without the need to strictly control the etching amount.

### <Fifth Embodiment>

The fifth embodiment differs from the first embodiment in that it treats an intermediate product as a multilayer wiring base substrate, which is a base substrate for the multilayer wiring board.

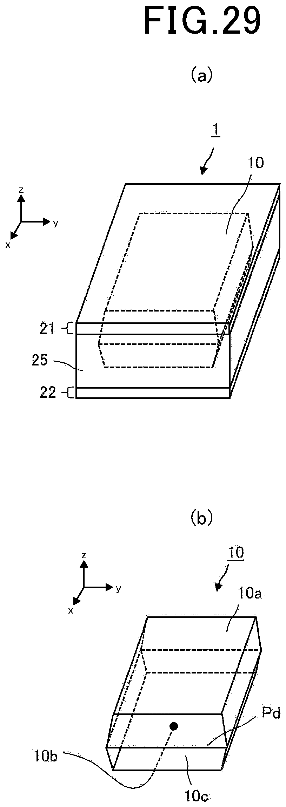

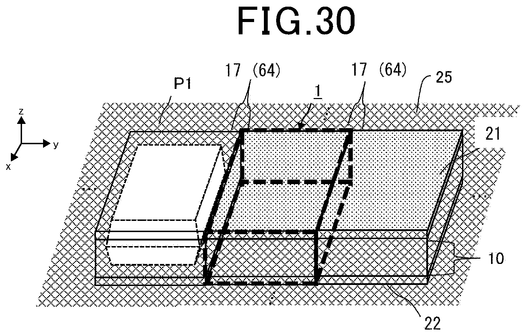

FIG. 29 is a schematic perspective view of a multilayer wiring board. FIG. 30 is a schematic diagram illustrating the multilayer wiring base substrate. In the following description, components that are the same as or similar to those of the first embodiment are given the same reference signs, and will not be described in detail or at all.

FIG. 29(a) shows a perspective view of the multilayer wiring board, and FIG. 29(b) shows a perspective view of the core substrate 10 included in the multilayer wiring board. FIG. 29 is a perspective view of the multilayer wiring board 1 shown in FIG. 1, with the outlines of the core substrate 10, the first wiring layer 21, the second wiring layer 22, and the insulating resin layer 25 illustrated schematically for ease of understanding.

Furthermore, as illustrated in FIG. 29(b), the core substrate 10 has the first surface 10a, the second surface 10b opposing the first surface 10a, and a side surface 10c connecting the peripheral edge of the first surface 10a and the peripheral edge of the second surface 10b. The first surface 10a and the second surface 10b are parallel surfaces, and the core substrate 10 is enclosed by the side surface 10c connecting the outer periphery (peripheral portion) of the first surface 10a and the outer periphery (peripheral portion) of the second surface 10b. When considering a cross-section parallel to the xy-plane, the cross-sectional area of the side surface 10c increases from the first surface 10a toward the intermediate portion Pd, and decreases from the intermediate portion Pd toward the second surface 10b. Although the side surface 10c is described as being composed of flat planes, it may not be planar because it is formed by etching the first separation-groove portions 17a and the second separation-groove portions 17b.

FIG. 30 is a perspective view of the structure illustrated in FIG. 19. FIG. 30 omits components such as the connection pads for ease of understanding. The figure shows an arrangement of three portions each corresponding to the multilayer wiring board 1. The multilayer wiring board 1 corresponds to the portion enclosed by a broken line, and represents, in the zy-plane, a section including the first wiring layer 21, the second wiring layer 22, and the core substrate 10 surrounded by the separation grooves 17. Although FIG. 30 shows three portions corresponding to multilayer wiring boards 1, the xy-plane contains a plurality of portions corresponding to multilayer wiring boards. One of the multilayer wiring boards is indicated by an outline.

The structure shown in FIG. 19 may also be considered an intermediate product of the multilayer wiring board 1, namely a multilayer wiring base substrate. That is, the multilayer wiring base substrate has the first surface 10a and the second surface 10b and includes a plurality of multilayer wiring boards, the multilayer wiring base substrate further including: a first wiring layer that is a wiring layer formed on the first surface 10a; a second wiring layer that is a wiring layer formed on the second surface 10b; and a separation groove 17 used to singulate the multilayer wiring boards, wherein, in a cross-sectional view, when edge portions of the separation groove 17 on the first surface 10a and the second surface 10b are connected by a straight line, an edge portion at the central part Pd of a side surface of the separation groove 17 is formed at a central region of the separation groove relative to the straight line, and the separation groove 17 is filled with an insulating resin.

The scope of the present invention is not limited to the exemplary embodiments illustrated and described herein, but includes various modifications. For example, the above embodiments have been described in detail to clearly explain the present invention, but the present invention need not include all the components described.

Furthermore, it is possible to replace part of the components of one embodiment with components of another embodiment, and it is also possible to add components of one embodiment to another embodiment. It is also possible to add other components to, remove components from, or replace components of each embodiment.

The present invention encompasses all embodiments that achieve effects equivalent to those intended by the present invention.

For example, although the present disclosure describes forming through-holes and separation grooves, it is not limited thereto. For example, only separation grooves may be formed without forming through-holes.

Aspects that may constitute the content of the present invention are described below, but the invention is not limited thereto.

### (Aspect 1)

A multilayer wiring board including: a core substrate having a first surface, a second surface opposing the first surface, and a side surface connecting peripheral portions of the first surface and the second surface; a first wiring layer that is a wiring layer formed on the first surface; and a second wiring layer that is a wiring layer formed on the second surface, wherein,
in a cross-sectional view along a direction perpendicular to the first surface and the second surface, the side surface has a shape that protrudes outward from the core substrate beyond a straight line connecting an intersection point of the first surface and the side surface with an intersection point of the second surface and the side surface, and
the side surface is covered by an insulating resin portion.

### (Aspect 2)

The multilayer wiring board according to aspect 1, wherein a position between the first surface and the second surface where the side surface protrudes the most is referred to as an intermediate portion,
the core substrate further includes a through-hole extending from the first surface to the second surface, and, in the cross-sectional view, the opening width of an opening of the through-hole in the first surface decreases toward the intermediate portion, and the opening width of an opening of the through-hole in the second surface decreases toward the intermediate portion,
the multilayer wiring board further includes a through-electrode that includes a seed layer and provides electrical connection between the first surface and the second surface through the through-hole, and
the first wiring layer includes a first conductive portion connected to the through-electrode, the second wiring layer includes a second conductive portion connected to the through-electrode, and the first and second conductive portions are electrically connected through the through-electrode.

### (Aspect 3)

The multilayer wiring board according to aspect 1 or 2, wherein the first and second wiring layers include an insulating resin layer, and
the insulating resin portion covering the side surface is made of the same type of insulating resin material as that forming the insulating resin layer.

### (Aspect 4)

The multilayer wiring board according to any one of aspects 1 to 3, wherein the insulating resin portion covering the side surface of the core substrate has a thickness of 50 µm or more,
the core substrate has a thickness within the range of 150 µm or more and 2000 µm or less, and
the insulating resin layer has a relative permittivity within the range of 3.1 or more and 3.5 or less, and a dielectric loss tangent within the range of 0.002 or more and 0.012 or less.

### (Aspect 5)

The multilayer wiring board according to any one of aspects 1 to 4, wherein the side surface of the core substrate has a plurality of recesses having a substantially rectangular shape and formed by a plurality of vertical ridges and horizontal ridges, and the rectangular shape has a horizontal dimension of 5 µm or more and 20 µm or less, and a vertical dimension of 2 µm or more and 25 µm or less.

### (Aspect 6)

The multilayer wiring board according to any one of aspects 1 to 5, wherein the vertical or horizontal ridges have a PV of 1.8 µm or more and 10.6 µm or less.

### (Aspect 7)

The multilayer wiring board according to any one of aspects 1 to 6, wherein the recesses have a depth of 0.5 µm or more and 11 µm or less.

### (Aspect 8)

The multilayer wiring board according to any one of aspects 1 to 7, wherein the insulating resin portion on the side surface of the core substrate has a thickness of 52.8 µm or more.

### (Aspect 9)

A method for manufacturing a multilayer wiring board using a base substrate having a first surface and a second surface opposing the first surface, the method including:
a first step of forming first modified portions by laser irradiation from the first surface side of the base substrate at a first through-hole position that is a position where a first through-hole portion is to be formed, the first through-hole portion extending from the first surface to an intermediate portion of the base substrate and constituting part of a through-hole penetrating the base substrate from the first surface toward the second surface, and at a first singulation-line position indicating a position where a first separation-groove portion is to be formed, the first separation-groove portion extending from the first surface to the intermediate portion of the base substrate and constituting part of a separation groove for separating a multilayer wiring board from the base substrate;
a second step of removing the first modified portions by etching from the first surface side to form the first through-hole portion and the first separation-groove portion;
a third step of disposing a conductive member from the first surface side to form a first through-electrode and a first conductive portion;
a fourth step of depositing an insulating resin material on the first surface side to form a first wiring layer;
a fifth step of forming second modified portions by laser irradiation from the second surface side of the base substrate at a second through-hole position that is a position where a second through-hole portion is to be formed, the second through-hole portion extending from the second surface to the intermediate portion of the base substrate and constituting part of the through-hole, and at a second singulation-line position that is a position where a second separation-groove portion is to be formed, the second separation-groove portion extending from the second surface to the intermediate portion of the base substrate and constituting part of the separation groove;
a sixth step of removing the second modified portions by etching from the second surface side to form the second through-hole portion and the second separation-groove portion;
a seventh step of disposing a conductive member from the second surface side to form a second through-electrode and a second conductive portion;
an eighth step of depositing the insulating resin material on the second surface side to form a second wiring layer; and
a ninth step of singulating along the separation groove to separate the multilayer wiring board.

### (Aspect 10)

The method for manufacturing a multilayer wiring board according to aspect 9, wherein
the side surface of the singulated multilayer wiring board is covered by the insulating resin material.

### (Aspect 11)

The method for manufacturing a multilayer wiring board according to aspect 9 or 10, wherein,
in the sixth step, the base substrate after the etching has a thickness within the range of 150 µm or more and 2000 µm or less,
the insulating resin material covering the side surface of the multilayer wiring board has a thickness of 50 µm or more, and
the insulating resin material has a relative permittivity within the range of 3.1 or more and 3.5 or less, and a dielectric loss tangent within the range of 0.002 or more and 0.012 or less.

### (Aspect 12)

The method for manufacturing a multilayer wiring board according to any one of aspects 9 to 11, wherein
the first separation-groove portion in the first step and the second separation-groove portion in the fifth step have an overlap ratio of through-holes in the separation groove of 40% or more and 90% or less.

### (Aspect 13)

The method for manufacturing a multilayer wiring board according to any one of aspects 9 to 12, wherein
in the second step and the sixth step, the processing width of the intermediate portion of the through-hole in the separation groove/the opening width of the through-hole in the separation groove is 0.88 or more.

### (Aspect 14)

A multilayer wiring base substrate including:
a base substrate having a first surface and a second surface;
at least one first wiring layer region that is a region including a wiring layer formed on the first surface;
at least one second wiring layer region that is a region including a wiring layer formed on the second surface;
a separation groove that extends from the first surface to the second surface to singulate at least one multilayer wiring board including the first and second wiring layer regions; and
an insulating resin portion disposed in the separation groove to bond adjacent multilayer wiring boards together, wherein
the width of the separation groove decreases from the first surface toward an intermediate portion of the base substrate and increases from the intermediate portion toward the second surface.

### (Aspect 15)

A multilayer wiring base substrate having a first surface and a second surface and including a plurality of multilayer wiring boards, the multilayer wiring base substrate further including:
a first wiring layer that is a wiring layer formed on the first surface;
a second wiring layer that is a wiring layer formed on the second surface; and
a separation groove used to singulate the multilayer wiring boards, wherein,
in a cross-sectional view, when edge portions of the separation groove on the first surface and the second surface are connected by a straight line, an edge portion at a central part of a side surface of the separation groove is formed at a central region of the separation groove relative to the straight line, and
the separation groove is filled with an insulating resin.

### [Reference Signs List]

- 1, 100: Multilayer wiring board
- 10: Core substrate
- 11: Through-hole
- 11a: First through-hole
- 11b: Second through-hole
- 12: Through-electrode
- 12a: First through-electrode
- 12b: Second through-electrode
- 13: Capacitor electrode
- 14: Dielectric layer
- 15: Hydrofluoric acid-resistant metal layer
- 16: Wiring
- 17: Separation groove
- 17a: First separation-groove portion
- 17b: Second separation-groove portion
- 17T: Opening width of separation groove
- 17B: Processing width of central portion of separation groove
- 21, 121: First wiring layer
- 22, 122: Second wiring layer
- 24: Insulating resin portion
- 25: Insulating resin layer
- 31, 32: Conductive electrode
- 41, 42: Through-electrode connection portion
- 51: Semiconductor device bonding pad
- 52: Semiconductor device bonding solder
- 53: Substrate bonding pad
- 54: Substrate bonding solder
- 55: Solder resist
- 60: Glass substrate
- 65, 65a, 65b, 65-1, 65-2: Laser-modified portion
- 65T: Transfer mark of laser-modified portion
- 70: First support
- 71: First adhesive layer
- 72: Blade

## Claims

1. A multilayer wiring board comprising:
a core substrate having a first surface, a second surface opposing the first surface, and a side surface connecting peripheral portions of the first surface and the second surface;
a first wiring layer that is a wiring layer formed on the first surface; and
a second wiring layer that is a wiring layer formed on the second surface, wherein,
in a cross-sectional view along a direction perpendicular to the first surface and the second surface, the side surface has a shape that protrudes outward from the core substrate beyond a straight line connecting an intersection point of the first surface and the side surface with an intersection point of the second surface and the side surface, and
the side surface is covered by an insulating resin portion.

2. The multilayer wiring board according to claim 1, wherein
a position between the first surface and the second surface where the side surface protrudes the most is referred to as an intermediate portion,
the core substrate further includes a through-hole extending from the first surface to the second surface, and, in the cross-sectional view, the opening width of an opening of the through-hole in the first surface decreases toward the intermediate portion, and the opening width of an opening of the through-hole in the second surface decreases toward the intermediate portion,
the multilayer wiring board further includes a through-electrode that includes a seed layer and provides electrical connection between the first surface and the second surface through the through-hole, and
the first wiring layer includes a first conductive portion connected to the through-electrode, the second wiring layer includes a second conductive portion connected to the through-electrode, and the first and second conductive portions are electrically connected through the through-electrode.

3. The multilayer wiring board according to claim 1, wherein
the first and second wiring layers include an insulating resin layer, and
the insulating resin portion covering the side surface is made of the same type of insulating resin material as that forming the insulating resin layer.

4. The multilayer wiring board according to claim 3, wherein
the insulating resin portion covering the side surface of the core substrate has a thickness of 50 µm or more,
the core substrate has a thickness within the range of 150 µm or more and 2000 µm or less, and
the insulating resin layer has a relative permittivity within the range of 3.1 or more and 3.5 or less, and a dielectric loss tangent within the range of 0.002 or more and 0.012 or less.

5. The multilayer wiring board according to claim 1, wherein
the side surface of the core substrate has a plurality of recesses having a substantially rectangular shape and formed by a plurality of vertical ridges and horizontal ridges, and the rectangular shape has a horizontal dimension of 5 µm or more and 20 µm or less, and a vertical dimension of 2 µm or more and 25 µm or less.

6. The multilayer wiring board according to claim 5, wherein
the vertical or horizontal ridges have a PV of 1.8 µm or more and 10.6 µm or less.

7. The multilayer wiring board according to claim 5, wherein
the recesses have a depth of 0.5 µm or more and 11 µm or less.

8. The multilayer wiring board according to claim 1, wherein
the insulating resin portion on the side surface of the core substrate has a thickness of 52.8 µm or more.

9. A method for manufacturing a multilayer wiring board using a base substrate having a first surface and a second surface opposing the first surface, the method comprising:
a first step of forming first modified portions by laser irradiation from the first surface side of the base substrate at a first through-hole position that is a position where a first through-hole portion is to be formed, the first through-hole portion extending from the first surface to an intermediate portion of the base substrate and constituting part of a through-hole penetrating the base substrate from the first surface toward the second surface, and at a first singulation-line position indicating a position where a first separation-groove portion is to be formed, the first separation-groove portion extending from the first surface to the intermediate portion of the base substrate and constituting part of a separation groove for separating a multilayer wiring board from the base substrate;
a second step of removing the first modified portions by etching from the first surface side to form the first through-hole portion and the first separation-groove portion;
a third step of disposing a conductive member from the first surface side to form a first through-electrode and a first conductive portion;
a fourth step of depositing an insulating resin material on the first surface side to form a first wiring layer;
a fifth step of forming second modified portions by laser irradiation from the second surface side of the base substrate at a second through-hole position that is a position where a second through-hole portion is to be formed, the second through-hole portion extending from the second surface to the intermediate portion of the base substrate and constituting part of the through-hole, and at a second singulation-line position that is a position where a second separation-groove portion is to be formed, the second separation-groove portion extending from the second surface to the intermediate portion of the base substrate and constituting part of the separation groove;
a sixth step of removing the second modified portions by etching from the second surface side to form the second through-hole portion and the second separation-groove portion;
a seventh step of disposing a conductive member from the second surface side to form a second through-electrode and a second conductive portion;
an eighth step of depositing the insulating resin material on the second surface side to form a second wiring layer; and
a ninth step of singulating along the separation groove to separate the multilayer wiring board.

10. The method for manufacturing a multilayer wiring board according to claim 9, wherein
the side surface of the singulated multilayer wiring board is covered by the insulating resin material.

11. The method for manufacturing a multilayer wiring board according to claim 10, wherein,
in the sixth step, the base substrate after the etching has a thickness within the range of 150 µm or more and 2000 µm or less,
the insulating resin material covering the side surface of the multilayer wiring board has a thickness of 50 µm or more, and
the insulating resin material has a relative permittivity within the range of 3.1 or more and 3.5 or less, and a dielectric loss tangent within the range of 0.002 or more and 0.012 or less.

12. The method for manufacturing a multilayer wiring board according to claim 9, wherein
the first separation-groove portion in the first step and the second separation-groove portion in the fifth step have an overlap ratio of through-holes in the separation groove of 40% or more and 90% or less.

13. The method for manufacturing a multilayer wiring board according to claim 9, wherein
in the second step and the sixth step, the processing width of the intermediate portion of the through-hole in the separation groove/the opening width of the through-hole in the separation groove is 0.88 or more.

14. A multilayer wiring base substrate comprising:
a base substrate having a first surface and a second surface;
at least one first wiring layer region that is a region including a wiring layer formed on the first surface;
at least one second wiring layer region that is a region including a wiring layer formed on the second surface;
a separation groove that extends from the first surface to the second surface to singulate at least one multilayer wiring board including the first and second wiring layer regions; and
an insulating resin portion disposed in the separation groove to bond adjacent multilayer wiring boards together, wherein
the width of the separation groove decreases from the first surface toward an intermediate portion of the base substrate and increases from the intermediate portion toward the second surface.

15. A multilayer wiring base substrate having a first surface and a second surface and comprising a plurality of multilayer wiring boards, the multilayer wiring base substrate further comprising:
a first wiring layer that is a wiring layer formed on the first surface;
a second wiring layer that is a wiring layer formed on the second surface; and
a separation groove used to singulate the multilayer wiring boards, wherein,
in a cross-sectional view, when edge portions of the separation groove on the first surface and the second surface are connected by a straight line, an edge portion at a central part of a side surface of the separation groove is formed at a central region of the separation groove relative to the straight line, and
the separation groove is filled with an insulating resin.
